(19) Europäisches Patentamt

European Patent Office

Office européen des brevets

(11) **EP 3 228 192 A2**

(12) **EUROPEAN PATENT APPLICATION**

(43) Date of publication:
**11.10.2017 Bulletin 2017/41**

(51) Int Cl.:
*A22C 25/00* (2006.01)          *A23L 17/20* (2016.01)
*F24J 2/46* (2006.01)          *H01L 51/42* (2006.01)

(21) Application number: **17162599.9**

(22) Date of filing: **23.03.2017**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(30) Priority: **30.03.2016 EP 16162925**

(71) Applicant: **BASF SE
67056 Ludwigshafen am Rhein (DE)**

(72) Inventors:
• **Massonne, Klemens
67098 Bad Dürkheim (DE)**
• **Vieira, Salome
Lisboa (PT)**
• **Lourenco, Maria Jose
Lisboa (PT)**
• **Nieto de Castro, Carlos
Lisboa (PT)**

(74) Representative: **Eisenführ Speiser
Patentanwälte Rechtsanwälte PartGmbB
Postfach 31 02 60
80102 München (DE)**

(54) **EXTRACTION AND USE OF MELANIN OR MELANIN PARTICLES FOR SOLAR THERMAL ENERGY CONVERSION**

(57)    The present invention provides renewable and sustainable materials suitable for solar thermal energy conversion. Provided are methods for isolating melanin or melanin particles from the ink sac of a *Cephalopoda* animal as well as parameters for characterizing melanin or melanin particles, particularly their physic-chemical properties. Further provided is a solar thermal energy selective absorber material comprising melanin or melanin particles, a solar lacquer or a solar paint comprising as a pigment melanin or melanin particles and a solar thermal system comprising melanin or melanin particles. In addition, there is provided the use of melanin or melanin particles as pigment, for example for solar lacquers or solar paints, or as selective absorber for direct absorption solar collectors or for use in a heat transfer fluid and/or within a solar thermal system in general.

EP 3 228 192 A2

**Description**

**Technical Field**

The present invention provides renewable and sustainable materials suitable for solar thermal energy conversion. Provided are methods for isolating melanin or melanin particles from the ink sac of a *Cephalopoda* animal as well as parameters for characterizing melanin or melanin particles, particularly their physico-chemical properties. Further provided is a solar thermal energy selective absorber material comprising melanin or melanin particles, a solar lacquer or a solar paint comprising as a pigment melanin or melanin particles and a solar thermal system comprising melanin or melanin particles. In addition, there is provided the use of melanin or melanin particles as pigment, for example for solar lacquers or solar paints, or as selective absorber for direct absorption solar collectors or for use in a heat transfer fluid and/or within a solar thermal system.

**Background of the Invention**

Rising energy costs, pronounced urban heat-island effect and global warming increase the need for intelligent solar heat management solutions. Currently, about 47% of all energy consumed worldwide is used for heating in general, comprising room heating, warm water and any kind of process heat. The relevant temperature range for this energy production is around 100°C lying in a range of 60°C to 120 °C. One possibility to reduce this consumption in favour of sustainable energy sources is the generation of warm water by converting the energy as provided by sunlight by means of solarthermics. Solar thermal systems working in the relevant temperature range for heat production, however, will not work in a competitive way at many locations in comparison to conventional techniques including heating of water via natural gas or by means of electrical energy (see e.g. IEA: technology road map: Solar Heating and Cooling 2012; https://www.iea.org/publications/freepublications/publication/Solar Heating Cooling Roa dmap 2012 WEB.pdf).

Therefore, it is of key importance for reducing costs of solar thermal systems to reduce the costs for material, installation and above all, to increase the efficiency of the conversion of solar energy into heat, an increased efficiency meaning that the same amount of heat can be produced and harvested by a smaller collector area so that fewer material has to be used.

On the other side when facing smaller and more efficient collectors, usually higher costs will be associated with the provision of suitable absorber materials supporting this increased higher efficiency in solar thermal energy conversion. From a practical point of view this implies finding an optimum compromise. Furthermore, there is a persisting need in finding better absorber materials for use in solar thermal systems, especially as part of the collectors.

Solar thermal collectors are used to convert the energy of sunlight into heat. The collectors contain a surface absorbing solar radiation. Said surface is in contact with a heat transferring material, usually a fluid, i.e. a liquid or a gas. By means of thermal isolation, the solar thermal collector assembly is protected from heat loss. Usually, the side of the absorber forming the sun exposed position is covered with glass and isolated with the help of an air layer. The sun radiation can thus reach the absorber layer and heat loss is minimized by means of efficient heat conduction. For a revue on solar energy materials see Claes G. Granqvist, DOI: 10.1002/0471238961.solagran.a01, Kirk-Othmer Encyclopedia of chemical technology; 27 January 2006.

The absorber layer should have a high absorption in the wavelength range of sun radiation (below 2 micron), so that the majority of the energy of the solar radiation can indeed be converted into heat. Radiation loss then occurs due to the heat radiation of the warmed media. Wavelength and intensity of the radiation can be approximated by a black body (Planck's law of radiation). With the temperature increasing, the wavelength gets smaller and the intensity increases. At 100 °C, for example, the maximum of heat radiation/thermal radiation is around 5 micron. Those layers having a high and uniform absorption over the whole wavelength range starting from UV to near-IR are termed unselective absorbers. Due to the high loss of radiation those unselective absorbers have a relatively low efficiency, i.e. the ratio of exploitable heat energy to irradiated energy is low, especially at higher temperatures. Unselective absorbers are thus predominantly used in solar heating systems for swimming baths, where low temperatures are needed, and/or in areas having a high solar radiation. Examples for unselective absorbers are black pigments (e.g. soot or carbon blacks) which are used in so-called solar lacquer or solar lacquer coatings/paints. These lacquers have an advantageous low price and are simple in application.

To minimize heat loss by radiation, the absorption in the infrared (IR) range should be as small as possible. For opaque bodies the following formula applies:

$$\%absorption + \%reflection = 100\%$$

The absorption behavior should ideally have a rapid change from 100% at low wavelength to 0% at high wavelength. This change should occur at wavelengths between about 2 and 3 micron between the areas of sun irradiation and radiation of the warmed collectors.

Absorbers layers showing such a behavior are also called selective absorbers and can have efficiencies up to 90% or even more. The most commonly used selective absorbers are coatings made of metal particles which are embedded into a ceramic dielectric ("Cermet"). The spectral selectivity is influenced by the materials used, the thickness of the film, the particle concentration and their gradient as well as the form and orientation of the particles. Presently, the application of those layers comprising at least one selective absorber onto the substrate is usually conducted with the help of complex and expensive physical vacuum techniques like sputtering.

Galvanic processes are also suitable to generate selective Ni and Cr layers (chrome black and nickel black). They have, however, the disadvantage of a high energy consumption and the drawback to require the use of toxic chemicals during manufacturing. Therefore, they are no longer widely used and there is a need in replacing these materials by environmentally friendly substances.

Selective paintings typically contain a strongly absorbing pigment within an IR-transparent binder. The used pigments are heavy metal oxides (Fe, Mn, Cu). Herewith, efficiencies in the range of about 70% can be achieved in comparison to about 90% as detailed for the above thin films. Still, the selective paintings are easier and consequently cheaper regarding their manufacturing as they are applied as painting rather than by sputtering. Additionally, paintings have the advantage of easier maintenance and repair which is not possible on-site for sputtered systems.

Therefore, there exists an ongoing need in developing and defining new materials which are suitable as selective absorbers and which are suitable to overcome the disadvantages detailed above. For sustainability reasons, especially the provision of a natural renewable material suitable for efficient solar thermal energy conversion would thus represent a great improvement over the current state of the art.

JP 2009 046621 A discloses the isolation of ink from cuttlefish. The object as disclosed is the provision of melanin particles having a narrow particle size distribution. Disclosed is a method of cleaning cuttlefish ink pigment particles using a first enzymatic reaction, a filtration step and a second enzymatic reaction. Said particles are said to be useful as toner, as aqueous or oily ink, or as a hair dye solution. However, the disclosed method is very time consuming and thus expensive as it proceeds through several enzymatic steps.

Scientific publications disclose the isolation of melanin from fresh ink sacs by slurrying the ink sac material in water or a salt solution followed by centrifugation or decantation and subsequent washing (see e.g. Pigment and Cell Research 1992, 5,143 edit 2003, 16, 72; edit 2003, 16, 606). Drying is, for example, achieved by air drying or with the help of freeze-drying (Pigment and Cell Research 2005, 18, 42; Comp. Biochem. Physiol. 1980, 68B, 415). For removing impurities associated with the ink sac the material is further treated with organic solvents and/or acids or bases (see e.g. Biochimica and Biophysica Acta 1988, 964, 193; Biochemische Zeitschrift 1909, 16, 37).

Melanin is a broad term for the group of natural pigments which can be found in most organisms. It is produced by the oxidation of the amino acid tyrosine followed by polymerization. Basic types of melanin have been described: eumelanin, pheomelanin and neuromelanin, wherein the most common type of melanin is eumelanin. Two types of eumelanin exist, brown eumelanin and black eumelanin. Pheomelanin is a cysteine-containing red polymer of benzothiazine units. Neuromelanin can be found in the brain, whereas its precise function still remains partially obscure. Concerning eumelanins and phaeomelanins, the enzyme tyrosinase acts to change the tyrosine into DOPA (3,4-dihydroxyphenylalanine), and then into dopaquinone. The dopaquinone can be converted to leucodopachrome and then can follow the pathway to produce eumelanins. Alternatively, the dopaquinone can combine with the amino acid cysteine by another pathway to produce benzothiazines and phaeomelanins.

Notably, cephalopod ink is a dark pigment contained in the ink sacs of animals belonging to the class of *Cephalopoda.* Usually the pigment is used as an escape mechanism obscuring the predator's view and thus and thus allowing the cephalopod to make a rapid retreat by chatting away. Nearly all cephalopods are able to release ink. The dark color is caused by the main constituent of the ink sac, melanin. Among biopolymers, melanins are unique in several aspects. Due to the intrinsic chemical properties of melanins as biopolymers no easily reproducible methods exist allowing the accurate chemical characterization of melanins. Melanin pigments are insoluble in a broad range of solvents and pH and difficult to purify due to the heterogeneity with respect to their structural features.

It was shown that sepia melanin obtained from *Sepia officinalis* also called "sepiomelanin" or "sepia melanin" consists of more than 89% of eumelanin (see e.g. Bardani L. et al. "Comparative Mössbauer and infrared analysis of iron-containing melanins", Biochim. et Biophys. Acta, 716:1, pp. 8-15). This work and others have proposed that sepia melanin is a copolymer of eumelanin constituted of approximately 20% of units of 5,6-dihydroxyindole (DHI) and 75% of units of 5,6-dihydroxyindole-2-carboxylic acid (DHICA).

Cephalopod ink contains a number of different chemicals in a variety of different concentrations, depending on the species. The main constituents are melanin and mucus. Several other constituents have been described, *inter alia,* comprising tyrosinase, dopamine and L-DOPA as well as small amounts of free amino acids including taurine, aspartic acid, glutamic acid, alanine and lysine (see e.g. Derby C.D. "Escape by Inking and Secreting: Marine Molluscs Avoid Predators Through a Rich Array of Chemicals and Mechanisms", Biol. Bull. 2013: 274-289, December 2007).

Magarelli et al. ("Purification, characterization and analysis of sepia melanin from commercial sepia ink (Sepia officinalis)", Revista CES Medicina Veterinaria y Zootecnia, Vol. 5, No. 2, 2010) disclose a method for extracting and purifying sepia melanin using a hydrochloric acid (0.5 - 3.0 M) treatment under mechanical or ultrasonic agitation. This method, however, aims at achieving a very high degree of purity and thus the separation of further constituents associated with melanin as far as possible as this work aims at providing quantitative studies of the chemical degradation of eumelanin polymers rather than at characterizing the function of sepia melanin.

WO 03/030194 A1 discloses a photoelectrical assembly (e.g. a regenerative photovoltaic cell) comprising mainly synthetic melanin-like material doped with metal ions as photosensitizer. Regarding the use of natural melanin or melanin-like material, WO 03/030194 A1 refers to extraction methods involving the progressive digestion of non-melanin related native accompanying tissue using a suitable enzyme, such as protease, followed by chemical and physical separation of the melanin-like biopolymer. WO 03/030194 A1, however, is completely silent as to the characterization of absorbance and thermal properties of melanin particles isolated from a natural source by freezing and subsequently extracting ink sac material

J. Phys. Chem. B., (Vol. 103 (51), 11428 (1999)) describes the optical properties of melanin. To this end, crude "solutions" or extracts of sepia ink in water are used. As the pigment is water insoluble, suspensions have to be used which are centrifuged to separate the coarser ink particles and further separating the solution by ultrafiltration into fractions of different molar mass (molecular weight). UV VIS spectra of these "solutions" show a steady decline of absorption between 200 and 800 nm wavelength. This decline is even steeper and shifted to shorter wavelengths if melanin particles have smaller molar mass. The sun emits electromagnetic radiation across most of the electromagnetic spectrum. The main portion, however, is in the visible range spanning from approximately 380 nm to approximately 780 nm. Therefore, it is an outstanding aim for materials used as absorbers in solar collectors to define and characterize substances having optimum optical absorbance in the visible range of light and not a steady decline as observed for the specific sepia melanin preparations according to J. Phys. Chem. B., (Vol. 103 (51), 11428 (1999) above.

Another trend in solar thermal energy systems is the use of so-called nanofluids. Nanofluids are colloid suspensions of nanoparticles in a basis fluid. The content of nanoparticles increases the thermal conductivity of the suspension in comparison to the basis fluid (see Renewable and Sustainable Energy Reviews 2015, 43, 164). Therefore, typical applications for nanofluids are heat transfer fluids and cooling agents. The thermal capacity of nanofluids can - in a good approximation - be described by the proportionate thermal capacities of the components (Renewable and Sustainable Energy Reviews 2014, 38, 88-98):

$$C_{nf} = (1-x_v)C_{bl} + x_v C_p \; ,$$

wherein

$C_{nf}$     is the thermal capacity of the nanofluid,

$x_v$     is the volume fraction of the nanoparticle

$C_{bl}$     is the thermal capacity of the basis fluid and

$C_p$     is the thermal capacity of the nanoparticle.

Another option for solar thermal solutions is the use of so-called "Direct absorption solar collectors". Those collectors use an absorbing fluid for absorbing solar radiation, wherein the absorbing fluid is simultaneously used as heat exchanger. In contrast to the solar collectors described above, this heat exchanger fluid is directly heated and thus the need for an absorbing layer as well as the heat transfer to the heat exchanger fluid is dropped (see Solar energy 1975, 17, 179-183). The fluid absorbing the radiation can for example flow through a transparent heat isolating pipe, e.g. a vacuum double shell glass pipe (CN 101915459 A). The fluid must have the capability to absorb solar radiation and it must be pumpable. Due to this reason the literature frequently describes the use of nanofluids for this purpose. The suspended nanoparticles effect light absorption, however, they are small enough so that the pumpability is not negatively influenced, especially if the content of particles is smaller than 1 vol.%. In addition, nanoparticles increase the efficiency as they have a positive contribution to the thermal conductivity in comparison to the heat exchanger fluid alone. Typically, nanoparticles consist of carbon, metals, such as silver or copper, and metal oxides (Nanoscale Research Letters 2011, 6, 225; Journal of Renewable and Sustainable Energy 2010, 2(3), 33102; Renewable and Sustainable Energy Reviews 2013, 28, 232-245; Energy Conversion and Management 2015, 100, 324-346).

As the size and composition of the nanoparticles can be used to influence the optical absorption, e.g. even for certain ranges of wavelengths, even combined photovoltaic/solar thermal systems can be built using nanoparticles. The thermal absorber layer converts that part of the radiation the wavelength of which is not suitable for the generation of electricity into heat, whereas the rest of the radiation can reach a photovoltaic active layer arranged below (see Light: Science and applications, 2012, 2, e34, doi: 10.1038/lsa.2012.34). Presently available nanomaterials are, however, often expensive due to high material and/or production costs.

The presently available highly selective coatings are applied with the help of costly and thus expensive methods, for example physical vapor deposition, to put said coatings onto the collector surface. In turn, the collector area has to be treated before mounting it in/onto a respective system. Therefore, any repair of the thus mounted system is not possible upon damage. In this case, the whole collector assembly has to be demounted and, possibly, replaced. This causes tremendous costs of maintenance.

It would thus represent an outstanding advantage over those materials currently used as selective absorbers for solar thermal energy systems to provide a selective absorber or a lacquer or solar paint which can be easily applied by means of painting or spraying, even at a system already installed. Any repair of a layer can then easily be accomplished locally without dismounting the whole system.

Nowadays, melanin is mainly a by-product or even waste-product when processing *Cephalopoda* animals for the food industry. Only a very small portion of the melanin or the melanin particles as obtainable from the ink sacks of a *Cephalopoda* animal are currently used as colorant or flavoring substance for the food industry. Several *Cephalopoda* animals, including *Sepia officinalis, Dosidicus gigas* or *Octopus vulgaris* are fished and processed for the food industry sector. The additional use of the ink or the further materials as comprised by the ink sack of such *Cephalopoda* animals would thus not increase the present catch rate, but it would rather improve the full and sustainable utilization of the whole material as obtainable from a *Cephalopoda* animal currently merely discarded as "waste-product".

As the present methods for providing selective absorber materials for solar thermal energy conversion usually use heavy metals during production, it would be another object of the present invention to present a material suitable as selective absorber as well as a corresponding isolation method which can proceed without the addition of chemicals or heavy metals to provide a pigment suitable as selective absorber, which is sustainable and environmentally friendly in its production.

In view of the persisting aim to provide highly efficient and cost sensitive absorber materials suitable for various applications, particularly for solar energy conversion, it was thus an object of the present invention to find absorber materials, possibly a nanomaterial, suitable for solar thermal energy systems having a working temperature range from about 60 to about 120 °C, wherein the absorber material has the advantage of providing a high efficiency for converting solar energy into heat due to material intrinsic physico-chemical properties, including absorption and simultaneously thermal properties. In addition, it was an object to provide a material which can be easily applied or exchanged without causing tremendous costs for maintenance of a solar energy conversion device. The materials should specifically show a high and stable absorption rate in the UV and visible light range and preferably a low absorbance (=high reflectivity) in the IR range emitted by sunlight. Furthermore, it was an object to provide efficient high-throughput compatible methods for providing such materials suitable as absorbers, especially for heat transfer fluids and thus suitable for solar thermal energy applications. This aim should be achieved using cost efficient materials, being easy and cheap in handling and processing and finally preferably originating from a renewable natural non fossil source allowing sustainable and environmentally friendly generation.

**Summary of the Invention**

The above-identified objects have been solved by providing in a first aspect a method for isolating melanin or melanin particles from the ink sac of a *Cephalopoda* animal comprising the following steps: (i) freezing of the *Cephalopoda* animal, or freezing of the ink sac removed from the *Cephalopoda* animal; (ii) thawing the *Cephalopoda* animal and removing the ink sac thereof, or thawing the ink sac from the *Cephalopoda* animal; (iii) slurrying the solid matter of the ink sac material of the *Cephalopoda* animal in a suitable solvent, preferably in water, to obtain a suspension comprising the melanin or the melanin particles from the *Cephalopoda* animal; (iv) optionally: filtration of the suspension comprising the melanin or the melanin particles from the *Cephalopoda* animal; and (v) optionally: drying the melanin or the melanin particles from the ink sac material of the *Cephalopoda* animal; and (vi) obtaining the melanin or the melanin particles from the ink sac material of the *Cephalopoda* animal.

In one embodiment of the method of the first aspect, the *Cephalopoda* animal is selected from the group consisting of *Sepia spp., Dosidicus* and *Octopus spp.,* preferably from *Sepia officinalis, Dosidicus gigas* and *Octopus vulgaris.*

In a further embodiment of the method of the first aspect, the melanin or the melanin particles have a particle size distribution in the range from about 10 nm to about 1,000 nm, preferably from about 10 nm to about 800 nm, more preferably from about 10 nm to about 500 nm and most preferably from about 50 nm to about 500 nm as measured by scanning electron microscopy.

In yet a further embodiment of the method according to the first aspect, the melanin or the melanin particles show an absorbance of above 90%, preferably of above 95% in the wavelength range from about 250 nm to about 950 nm and a decline of absorbance starting from about 85% to about 90% at a wavelength from about 1200 nm down to an absorbance of about 22% to about 50% at a wavelength of about 1600 nm as measured by diffuse reflectance spectroscopy.

In still another embodiment according to the method of the first aspect, the freezing step (i) comprises freezing the *Cephalopoda* animal, or freezing of the ink sac removed from the *Cephalopoda* animal at a temperature from about -196 °C to about 0°C, preferably at a temperature from about 0°C to about -78°C, and most preferably from about 0°C to about -20°C.

In yet a further embodiment according to the method of the first aspect, the method does not contain a step of removing product-related impurities, and/or wherein the melanin or the melanin particles are associated with organic material, wherein the organic material is derived from the ink sac of a *Cephalopoda* animal, or wherein the organic material is a synthetic organic material, optionally wherein the organic material comprises collagen.

In a second aspect, there are provided melanin or melanin particles obtainable by a method as detailed in any of the embodiments of the above first aspect, wherein the melanin or the melanin particles have a particle size distribution of from about 50 nm to about 500 nm as measured by scanning electron microscopy.

In a still further aspect, there is provided a solar thermal energy selective absorber material comprising melanin or melanin particles, preferably melanin or melanin particles from a *Cephalopoda* animal or melanin or melanin particles according to the second aspect of the present invention, or obtainable by a method according to any embodiment of the first aspect of the present invention.

In one embodiment related to solar thermal energy selective absorber material(s), the melanin or the melanin particles are isolated from a natural source, or synthetically, or recombinantly produced.

In a further embodiment related to solar thermal energy selective absorber materials, the melanin or the melanin particles are dispersed in a heat transfer fluid.

In a further aspect, there is provided solar lacquer or a solar paint comprising as a pigment melanin or melanin particles according to any embodiment of the second aspect of the present invention, or melanin or melanin particles produced as detailed in any embodiment of the first aspect of the present invention, or comprising a solar thermal energy selective absorber material comprising melanin or melanin particles according to any embodiment related to solar thermal energy selective absorber material(s).

In one embodiment of this aspect, the solar lacquer or the solar paint is independently selected from the group consisting of water-based coatings, preferably dispersions of a polyvinyl ester, a polyvinyl alcohol, a polyvinyl ether, a styrene-butadiene copolymer, or an acrylic, a low solvent high solid coating, preferably an acrylic coating, an unsaturated polyester coating, a polyurethane coating, or a melamine-based resin coating.

In yet a further aspect, there is provided a solar thermal system comprising melanin or melanin particles, preferably melanin or melanin particles from a *Cephalopoda* animal or melanin or melanin particles any embodiment of the second aspect of the present invention, or obtainable by a method according to any embodiment of the first aspect of the present invention, or comprising a solar thermal energy selective absorber material according to any of the above embodiments related to solar thermal energy selective absorber material(s), or comprising a solar lacquer or a solar paint according to any of the above embodiments related to a solar lacquer or a solar paint.

In a further aspect, there is provided the use of melanin or melanin particles, preferably melanin or melanin particles from a *Cephalopoda* animal, or of melanin or melanin particles according to any embodiment of the second aspect of the present invention, or of melanin or melanin particles obtainable by a method any embodiment of the first aspect of the present invention, as pigment for solar lacquers or solar paints, or as selective absorber for direct absorption solar collectors.

In one embodiment according to this aspect, the melanin or the melanin particles is/are used as selective absorber in a heat transfer fluid and/or within a solar thermal system. As the isolation of the melanin or the melanin particles according to the present disclosure as well as the provision of selective absorber materials based on melanin and melanin particles for solar thermal energy conversion provided herein is devoid of the use of metal ions and toxic chemicals, the methods and materials disclosed herein are ecologically beneficial, and, being derived from a natural source, sustainable and environmentally compatible.

Further aspects and embodiments of the present invention can be derived from the subsequent Detailed Description and the Drawings as well as the attached set of claims.

**Brief Description of the Drawings**

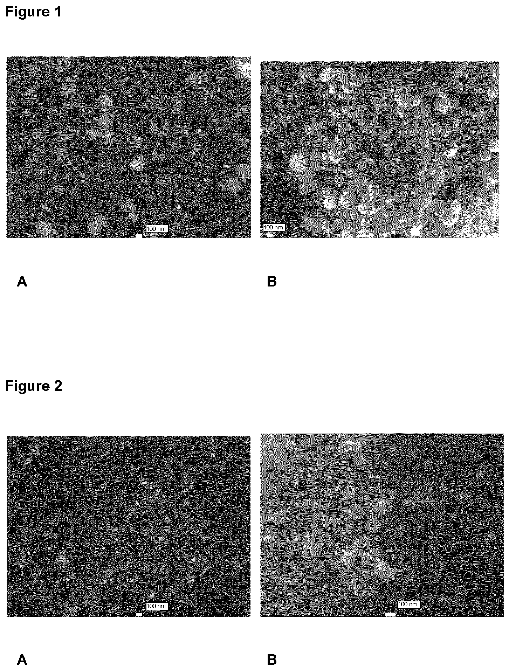

Figure 1 (Fig. 1) shows a scanning electron microscopy (SEM) image of melanin obtained from *Sepia officinalis* after centrifugation and freeze-drying. Magnification: x 30,000. Two different images (A) and (B) corresponding to the same material are provided. This sample is denoted as "MOld" in the following.

Figure 2 (Fig. 2) shows a scanning electron microscopy (SEM) image of melanin obtained from *Sepia officinalis* after isolation cooling, filtration and drying in a drying cabinet. Magnification: x 30,000. Two different images (A) and (B) corresponding to the same material are provided (see Example 1). This sample is denoted as "MF" in the following.

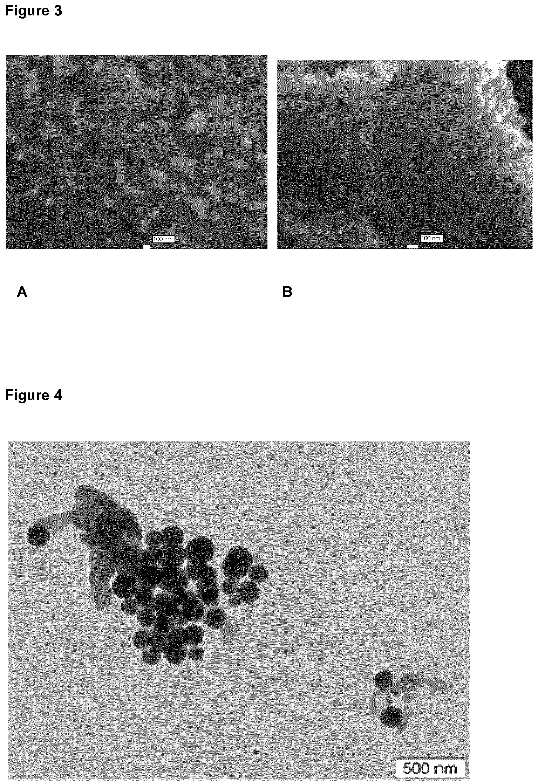

Figure 3 (Fig. 3) shows a scanning electron microscopy (SEM) image of melanin obtained from *Sepia officinalis* after isolation according to the method of the present invention as detailed in Example 2. Magnification: x 30,000. Two different images (A) and (B) corresponding to the same material are provided. This sample is denoted as "MC" in the following.

Figure 4 (Fig. 4) shows a transmission electron microscopy (TEM) image obtained as detailed in Example 4 showing the sample MC isolated according to a method as detailed in Examples 2 and 3.

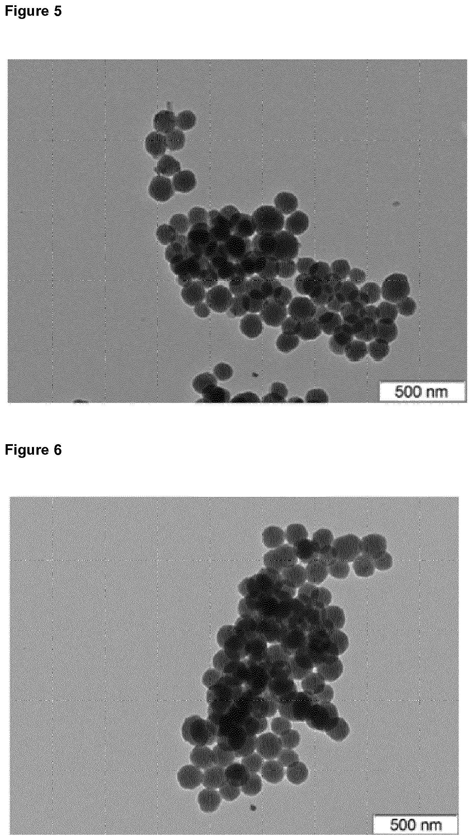

Figure 5 (Fig. 5) shows a transmission electron microscopy (TEM) image obtained as detailed in Example 4 showing the sample MCA A isolated according a method as detailed in Examples 2 and 3.

Figure 6 (Fig. 6) shows a transmission electron microscopy (TEM) image obtained as detailed in Example 4 showing the sample MCA BE isolated according a method as detailed in Examples 2 and 3.

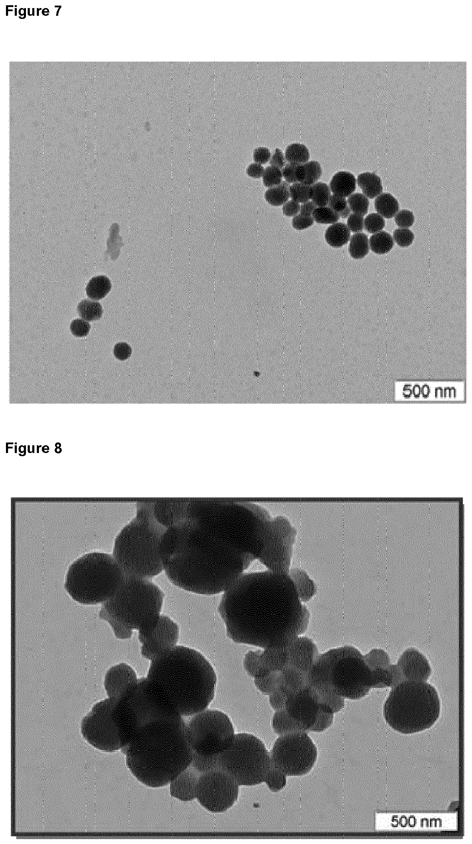

Figure 7 (Fig. 7) shows a transmission electron microscopy (TEM) image obtained as detailed in Example 4 showing the sample MCA BES isolated according a method as detailed in Example 3.

Figure 8 (Fig. 8) shows a transmission electron microscopy (TEM) image obtained as detailed in Example 4 showing the sample MCC isolated according a method as detailed in Examples 2 and 3.

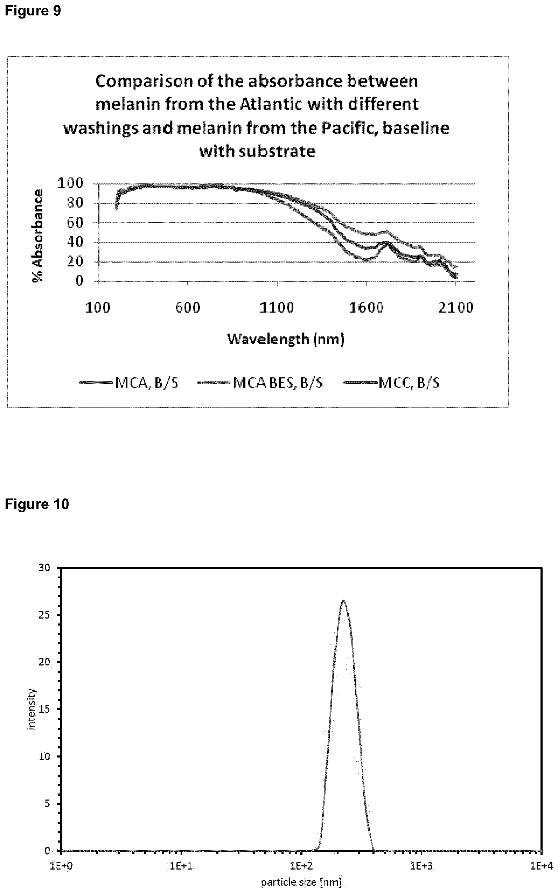

Figure 9 (Fig. 9) shows an absorbance curve as obtained by diffuse reflectance spectroscopy (DRS) experiments for different melanin samples as prepared according to the present invention. In this Figure, the curve running at the top corresponds to the sample MCA BES, B/S, the curve running in the middle corresponds to the sample MCC, B/S and the curve running at the bottom of the three curves corresponds to the sample MCA, B/S.

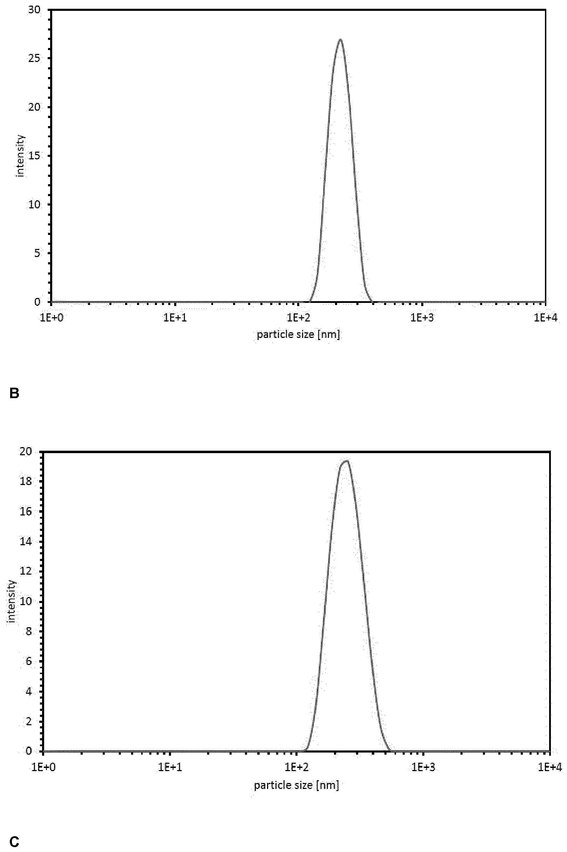

Figure 10 A-C (Fig. 10A-C) shows particle size distribution measurements according to Example 5. Fig. 10A shows the sample MC (frozen, 0.2 g/l in $H_2O$, filtrated (1.2 $\mu$m), 5 min US MW). Fig. 10B shows the sample MF (refrigerated, 0.2 g/l in $H_2O$, filtrated (1.2 $\mu$m), 5 min US MW). Fig. 10C shows the sample MC BE (frozen + BE, 0.1 g/l in $H_2O$, filtrated (1.2 $\mu$m), 5 min US MW).

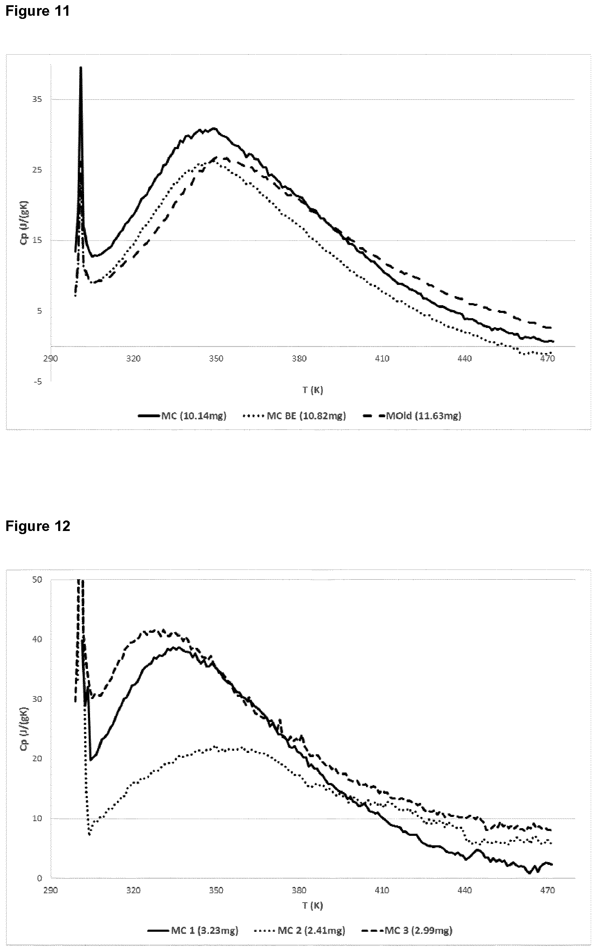

Figure 11 (Fig. 11) shows the data as obtained by a differential scanning calorimetry (DSC) experiment as detailed in Example 7 below. The heat capacity of the material MOld produced according to prior art methods is significantly lower than the heat capacity of material produced according to the methods of the present invention, namely MC, and the heat capacity is comparable with that of melanin washed with butoxyethanol from experiment 6 (MC BE, see Example 3 above.)

Figure 12 (Fig. 12) shows the results of a DSC measurement at various time points for the sample MC (see Example 7 below).

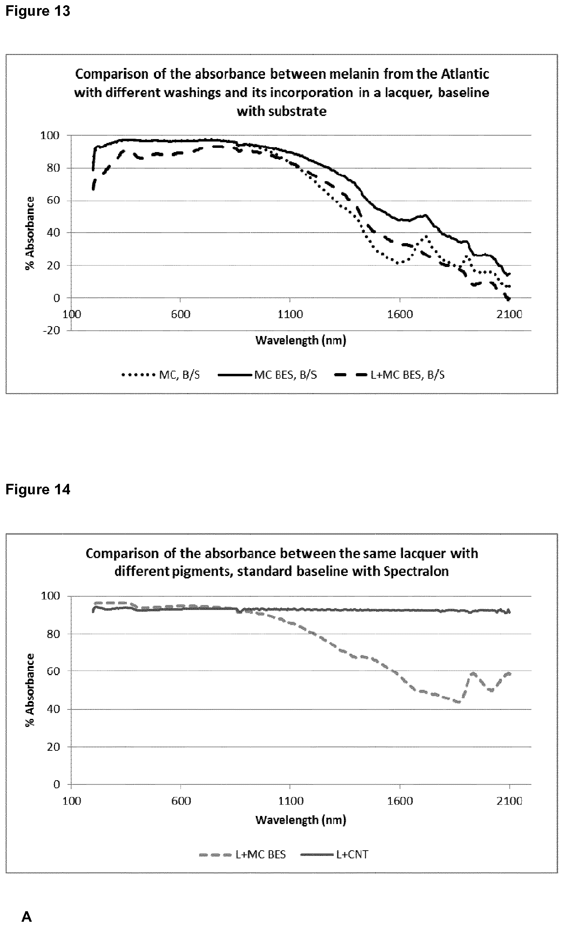

Figure 13 (Fig. 13) shows an absorbance curve as obtained by diffuse reflectance spectroscopy (DRS) experiments for different melanin samples as prepared according to the present invention in comparison to one melanin sample according to the present invention (MCA BES; in the Figure: L+MCA BES, B/S) incorporated into a transparent lacquer formulation.

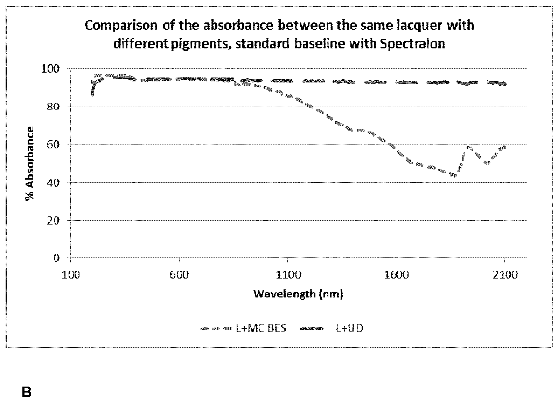

Figure 14A and B (Fig. 14A and B) shows an absorbance curve as obtained by diffuse reflectance spectroscopy (DRS) experiment when comparing a MCA BES based lacquer (L+MCA BES) according to the present invention to a lacquer based on carbon nanotubes (L+CNT) (Fig. 14A) or universal black (L+UD) (Fig. 14B) as pigment.

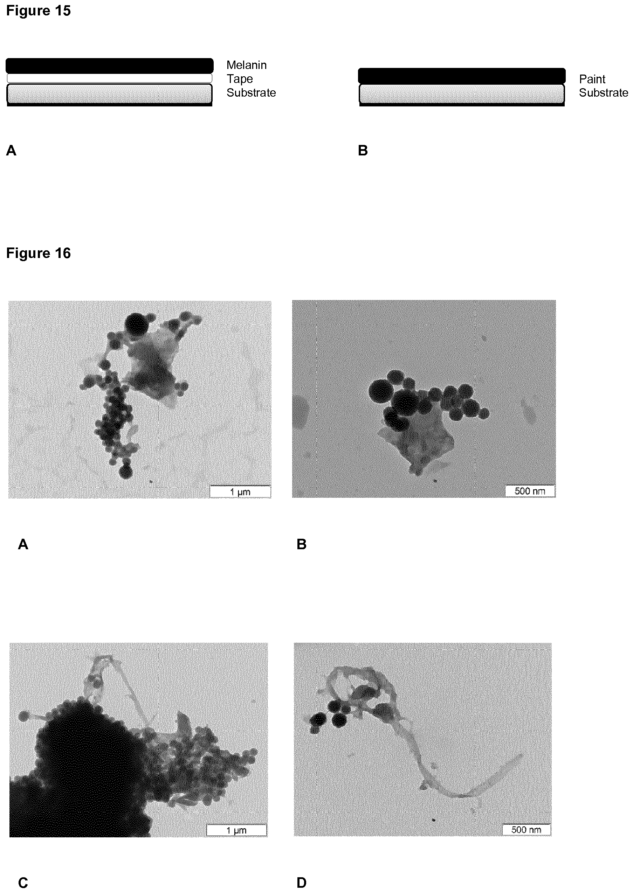

Figure 15 (Fig. 15) shows the schematic layered composition of a powder and a paint comprising melanin as disclosed herein. (A) shows a powder. Melanin solid samples are applied on a substrate with an intermediate double-sided bonding tape. (B) shows a paint, which can either comprise melanin, carbon nanotubes or a commercial universal black dye, dispersed in a commercial lacquer, applied on a substrate.

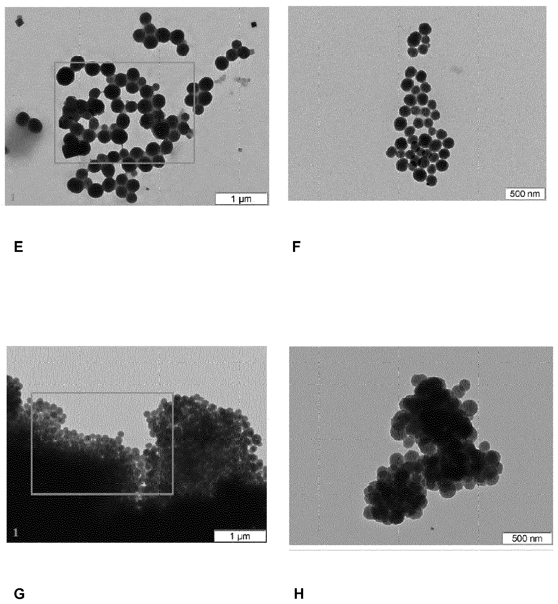

Figure 16 A-H (Fig. 16A-H) shows the result of transmission electron microscopy (TEM) image obtained as detailed in Example 5 showing the samples MOld (Fig. 16 A and B), MF (Fig. 16, C and D), MC (Fig. 16E and F) and MC BE (Fig. 16G and H) prepared according a method as detailed in Examples 1 to 3.

**Definitions**

The terms "melanin" or "melanin particle(s)" are used interchangeably herein and refer to a broad group of natural pigments found in a variety of organisms. Melanin is produced by the oxidation of the amino acid tyrosine followed by polymerization and represent complex biomolecules as detailed above. Therefore, the specific chemical composition of a melanin preparation might naturally vary depending on the origin of the melanin and the way of preparation. Melanin or melanin particles according to the present invention are obtained or derived from cephalopods, i.e. animals of the class *Cephalopoda* belonging to the phylum *Mollusaca.* The melanin or melanin particles can either be isolated from the animal or the ink sac thereof. Alternatively, the melanin can be produced synthetically by chemical synthesis, optionally accompanied by the admixture of further organic material after synthesis and purification, or recombinantly, e.g. using *Escherichia coli* or any other prokaryotic or eukaryotic host for expression of a melanin substance of interest.
The term selective absorber or selective surface as used herein is a means of increasing the operation temperature and/or efficiency in a solar thermal device or collector or a layer thereof. The selectivity is defined as the ratio of solar radiation-absorption to thermal infrared radiation-emission. Typical values for a selective surface might be 0.90 solar absorption and 0.10 thermal emissivity, but can range from 0.8/0.3 to 0.96/0.05.
The term recombinant as used herein refers to (semi)-artificial biomolecules, preferably a nucleic acid molecule or an amino acid molecule, which is produced artificially implying a targeted and purposive manipulation and/or modification achieved by means of molecular biology or protein engineering, e.g. by introducing a heterologous sequence into a host cell for recombinant production of the target biomolecule of interest.

**Detailed Description**

In a first aspect, the present invention is directed to a method for isolating melanin or melanin particles from the ink sac of a *Cephalopoda* animal comprising the following steps: (i) freezing of the *Cephalopoda* animal, or freezing of the ink sac removed from the *Cephalopoda* animal; (ii) thawing the *Cephalopoda* animal and removing the ink sac thereof, or thawing the ink sac from the *Cephalopoda* animal; (iii) slurrying the solid matter of the ink sac material of the *Cephalopoda* animal in a suitable solvent, preferably in water, to obtain a suspension comprising the melanin or the melanin particles from the *Cephalopoda* animal; (iv) optionally: filtration of the suspension comprising the melanin or the melanin particles from the *Cephalopoda* animal; and (v) optionally: drying the melanin or the melanin particles from the ink sac material of the *Cephalopoda* animal; and (vi) obtaining the melanin or the melanin particles from the ink sac material of the *Cephalopoda* animal.
Usually, according to prior art methods, melanin or melanin particles from *Cephalopoda* species are either directly processed to obtain the ink sac material and thus the melanin or melanin particles by slurrying the material followed by subsequent (freeze) drying. Alternatively, the material is filtered. This approach, however, is time-consuming and leads to a decrease in yield as the melanin particles can not fully be recovered from the filter material. Another approach is the attempt to prepare ultrapure particles using enzymatic approaches or by extracting remaining non-melanin ink sac material by organic solvents and/ or acid/base treatment. All these methods, however, lead to the provision of melanin material having a very narrow melanin particle size distribution in the range from about 100 to about 150 nm (see, e.g. Example 1 and Fig. 1). Some approaches (see e.g. J. Phys. Chem. B., (Vol. 103 (51), 11428 (1999) above) even try to specifically discard the coarse melanin particles without seeking to attribute a function to this fraction or the melanin material as a whole, let alone characterizing the physico-chemical properties of this specific fraction.
An ink sac is an anatomical feature that is found in many cephalopod mollusks used to produce the defensive cephalopod ink. With the exception of nocturnal and very deep water cephalopods, all coeloids (e.g. squid, octopus and *Sepia* (cuttlefish)) which dwell in light conditions have an ink sac. The natural function of the ink sac, from which ink can be expelled as a cloud of dark ink is the confusion of predators. The ink sac is a muscular bag which originated as an extension of the hind gut; it is a modified hypobranchial gland. It lies beneath the gut and opens into the anus, into which its contents - almost pure melanin - can be squirted; its proximity to the base of the funnel means that the ink can be distributed by ejected water as the cephalopod uses its jet propulsion. The ejected cloud of melanin is bound by mucus particles, so it forms a lump approximately the size and shape of the cephalopod, fixing the predator's attention while the mollusc itself makes a hasty escape
In one embodiment of the method according to the first aspect, any animal from the class *Cephalopoda* comprising an ink sac or the ink sac thereof can be used for the purpose of the present invention. In a preferred embodiment, the *Cephalopoda* animal is selected from the group consisting of *Sepia spp., Dosidicus* and *Octopus spp.,* preferably from *Sepia officinalis, Dosidicus gigas* and *Octopus vulgaris.* Further *Cephalopoda* animals are known to the skilled person, which are able to produce melanin. Said animals as melanin source are likewise suitable for the purpose of the present invention.

In one embodiment of the first aspect, further steps of storing and/or cooling and/or purifying the material can be comprised as associated with the transport and downstream manufacturing of this product from a natural source.

On one embodiment, a filtration step is used to further separate the melanin particles after slurrying. In another embodiment, a centrifugation step and/or a filtration step can be used. In certain embodiments, no filtration or centrifugation step is applied and the melanin particles are directly subjected to a drying step or to a further downstream processing step.

In a subsequent step according to the methods of the present invention the filter cake as obtained after specific freezing and optionally filtering can then be subjected to an additional washing step, especially wherein the washing is accomplished in water or another suitable solvent.

In a final step according to the methods of the present invention, the filter cake, preferably the after an additional washing step, can then be dried. Drying is preferably conducted in an electrical drying oven or any drying cabinet at a temperature of about 60 °C to about 100 °C, preferably about 75°C to about 90°C, but the skilled person in the art can easily define suitable drying conditions.

Notably the morphology of the melanin or the melanin particles as obtained according to the methods as disclosed in the present application and as defined using scanning electron microscopy (SEM) or as measured using transmission electron microscopy (TEM) show an overall morphology comparable to melanin particles as obtained by prior art methods, i.e. defined particles having a spherical shape can be obtained (see **Fig. 3**). There is, however, a significant difference in particle size distribution which could be obtained and measured for the melanin particles as obtained according to the methods of the present invention. Whereas melanin particles purified without a specific freezing step show a particle size distribution from about 100 $\mu$m to about 150 $\mu$m (see e.g. **Fig. 1** or **Fig. 2**), the particle size distribution of the melanin or the melanin particles according to the present invention is broader and could be defined to be between about 50 $\mu$m and about 500 $\mu$m (see **Fig. 3** to **8** and **11**). Without wishing to be bound by theory, these observations, which also influence the physical/chemical properties of the melanin particles according to the present invention, can be attributed to the fact that the specific method according to the present invention intentionally tries to isolate the whole population of melanin particles as obtainable from an ink sac from a *Cephalopoda* animal, whereas prior art methods seek to separate away larger and coarser melanin particle materials by means of centrifugation, chemical or enzymatic purification or filtration and thus intrinsically overlook the physical and chemical properties of a melanin preparation having a particle size distribution according to the present invention, which is simultaneously suitable as selective absorber material as well as a heat transfer material.

In a further embodiment according to the first aspect of the present invention, the melanin or the melanin particles have a particle size distribution in the range from about 10 nm to about 1,000 nm, preferably from about 10 nm to about 800 nm, more preferably from about 10 nm to about 500 nm and most preferably from about 50 nm to about 500 nm as measured by scanning electron microscopy.

For the purpose of the present disclosure, the terms particle size distribution and equivalent (spherical) diameter can be used interchangeably, as the melanin or the melanin particles are nearly spherical in shape. Instruments and corresponding parameters for measuring and defining a particle size distribution for the material as analyzed for the purpose of the present invention are described below within the Examples section.

Other than many prior art methods for purifying and/or characterizing melanin from a *Cephalopoda* source, it was surprisingly found that the physic-chemical properties of melanin or melanin particles, for example, the optical properties, vary for different fractions as obtainable from melanin from an ink sac of a *Cephalopoda* source. Whereas the prior art cited above (see e.g Figures 1 and 2 of J. Phys. Chem. B., (Vol. 103 (51), 11428 (1999)) always seeks to either provide a extremely pure melanin preparation, or simply discards large portions of the sediment and only characterizes the supernatant of *Cephalopoda* ink preparations, the present disclosure provides a detailed analysis of subfractions of melanin also including particles from the sediment having a different particle size distribution than melanin or melanin particles as described in the prior art. As evident from **Fig. 9,** it was found that the material as purified according to the present invention has optimum optical absorbance in the visible range of light and not a steady decline as observed for the specific sepia melanin preparations according to J. Phys. Chem. B., (Vol. 103 (51), 11428 (1999). An outstanding characteristic of the melanin or the melanin particles obtainable by the methods according to the present invention are the optical characteristics of these melanin samples. Those optical characteristics were measured using diffuse reflectance spectroscopy as described in detail in the examples section. In contrast to absorption data as obtained from the literature (J. Phys. Chem. B., (Vol. 103 (51), 11428 (1999))) the samples of the melanin or the melanin particles as obtained according to the methods of the present invention show a significantly different behavior, i.e. the absorption within the UV-VIS range up to about 1,200 nm is significantly higher than for material as characterized in the prior art.

Specifically, there is no decline of absorption between about 200 nm and 800 nm thus also comprising the visible light range which represents the most abundant portion of sunlight. These optical properties of the melanin or the melanin particles as isolated and/or prepared according to the methods of the present invention suggest the use thereof as selective absorber material, especially a solar thermal energy selective absorber material.

In a further embodiment according to the first aspect of the present invention, the melanin or the melanin particles show an absorbance of above 90%, preferably of above 95% in the wavelength range from about 250 nm to about 950 nm and a decline of absorbance starting from about 85% to about 90% at a wavelength from about 1,200 nm down to an absorbance of about 22% to about 50% at a wavelength of about 1,600 nm as measured by diffuse reflectance spectroscopy.

As evident from **Figs. 9,13** and **14**, the optical properties associated with the material as prepared according to the present invention is characterized in a steadily high absorption in the UV-VIS range as well as a steep decline in the near IR-wavelength range. Said characteristics are a prerequisite for materials suitable as absorbers for solar thermal energy conversion and the current prior art methods thus did not realize or appreciate that a separation of a huge portion of the melanin or melanin particles as obtainable from a *Cephalopoda* animal results in a preparation having different physic-chemical properties, which are, however, not suitable for the various products and uses as disclosed herein.

The significant differences as observed in the literature for melanin particles isolated and/or purified according to state of the art methods might be contributed to the fact that no specific freezing step is used for preparation and prior art methods specifically try to separate larger or coarser particles as found in the sediment, which is not further used, wherein the supernatant comprising small particles has been the object of said studies.

In yet a further embodiment according to the first aspect of the present invention, the freezing step (i) comprises freezing the *Cephalopoda* animal, or freezing of the ink sac removed from the *Cephalopoda* animal at a temperature from about -196 °C to about 0°C, preferably at a temperature from about 0°C to about -78°C, and most preferably from about 0°C to about -20°C, whereas this exemplary ranges reflect freezing conditions as obtainable by liquid nitrogen, dry ice and a salt-water mixture, respectively. In contrast to prior art methods, the present method comprises a freezing step. Other than a cooling step, the material as obtained from a *Cephalopoda* animal is thus completely frozen also influencing the various biomolecules the cellular and tissue structures as treated this way during the subsequent downstream processing. The time duration chosen for the freezing step can vary depending on the freezing temperature and conditions chosen. Any time can be used provided that the material subjected to the freezing step is fully frozen and the optimum time for the freezing step can thus be easily determined by the skilled person.

In a still further embodiment according to the first aspect of the present invention, the method does not contain a step of removing product-related impurities, and/or the melanin or the melanin particles are associated with organic material, wherein the organic material is derived from the ink sac of a *Cephalopoda* animal, or wherein the organic material is a synthetic organic material, optionally wherein the organic material comprises collagen.

The slurrying according to the first aspect of the present invention then serves to extract and isolate the crude melanin material from the ink sac of an animal. Preferably, the slurrying is accomplished in water. Filtering according to the methods of the present invention can then be accomplished by using a suitable filter. Such suitable filter papers and filtration methods are known to the person having skill in the art.

Product-related impurities as used in this context refer to any substance or material other than the substance of interest, i.e. melanin or melanin-particles according to the present disclosure, which are associated with the product in its natural environment or which get associated with the product of interest during processing and purification steps, e.g. due to breaking up cells and tissues. A product-related impurity in this context thus means any further substance being associated with or being co-isolated or co-purified with the substance of interest, wherein the substance of interest in this case are melanin or melanin particles. Such product-related impurities are derived from the *Cephalopoda* animal or the ink sac thereof, especially the mucus forming one of the major constituents of the ink sac comprising tyrosinase, amino acids, L-DOPA or dopamine and collagenous material.

As detailed above (see **Fig. 4 to 8** in comparison to each other), the presence of organic material, usually discarded by way of purification in prior art methods, can have beneficial effects concerning the physic-chemical properties of the melanin or melanin particles according to the present invention for the products and uses as disclosed herein, however, as evident from **Figures 16A to H** omitting a freezing step as suggested by the present invention will lead to material, which is aggregated with and sticking to organic material in an inhomogeneous way and therefore less suitable for the solar energy absorbing applications disclosed herein In one embodiment, such organic materials as naturally associated with the melanin or melanin particles in its natural environment are not further purified, in another embodiment, depending on the characteristics of the final melanin material to be achieved, the material can be further purified by methods known to the skilled person, including, *inter alia,* treatment with organic solvents and/or acids or bases or further mechanical purification steps including filtration, centrifugation or chromatographic steps. Alternatively, especially concerning embodiments, wherein synthetically or recombinant melanin or melanin particles are used, the material can be further subjected to a step of admixing the material with an organic material of interest, including *inter alia* mucus material from a *Cephalopoda* animal or embedding of the material into collagen. Any source of collagen can be used for the purpose of the present disclosure. The melanin or the melanin particles according to the methods of the first aspect of the present invention can thus be associated with organic material derived from the ink sac of a *Cephalopoda* animal, i.e. the natural organic material as present in the ink sac. In another embodiment according to the first aspect of the present invention synthetic organic material is provided, which can interact with and surround the melanin or the melanin particles as isolated according to the methods of the present invention. Notably, the melanin or melanin particles as isolated according to the methods of the present invention do not lose their overall morphology or particle size distribution when processed under various conditions. This fact is important, as it underpins that the melanin or the melanin particles as isolated according to the methods of the present invention can be used for a variety of applications, including the application in a variety of solvents or the application in the presence of an acid or base and especially the application over a profound temperature range. The morphology of the particles according to the present application can be preserved using either cold or warm water during preparation. Moreover, heating to 100 °C, 150 °C and even 200 °C does not influence the morphology of the melanin or the melanin particles as detailed above and as exemplified in the Examples section below. Likewise, the treatment with acids or bases ($NH_3$ aq 30 %)/solvent (e.g. toluene, acetone, cyclohexanone, dichloromethane, 2-Butoxyethanol)/ liquid nitrogen do not have an influence on the morphology of the melanin or the melanin particles isolated according to the methods of the present invention, nor are the thermal properties of the melanin or the melanin particles influenced by such a treatment. This fact represents a prerequisite for using the melanin or the melanin particles as selective absorber material or as pigment within heat transfer fluids or solar lacquers or solar paints as further detailed below, as the melanin material is stable over a high temperature working range without losing its optical and thermal properties.

Furthermore, the presence of organic material associated with the melanin or melanin particles as used for diffuse reflectance spectroscopy experiments additionally seems to improve the absorbent's behavior of the melanin or melanin particles according to the present invention, especially in the wavelength range from about 1,100 nm to about 2,100 nm, which is suitable for providing absorbers for the specific wavelength range. The significant differences as observed in the literature for melanin particles isolated and/or purified according to state of the art methods might be contributed to the fact that no specific freezing step is used for preparation and prior art methods specifically try to separate larger or coarser particles as found in the sediment, which is not further used, wherein the supernatant, or the fraction comprising small particles has been the object of said studies.

Melanin or melanin particles isolated from *Sepia officinalis* and *Dosidicus gigas* (s. Examples 2 and 3), both showed high absorption over the whole UV-Vis range as well as the desired low absorption at higher wavelengths (s. **Fig. 9**).

As shown in **Fig. 9** washing away of organic product-related impurities from the melanin or melanin particles according to the present invention resulted in a more pronounced flat decline of absorption above 1,100 nm and an increased absorption in the near infrared range. This optical characteristic, however, is especially unwanted for selective absorption materials used for absorbing sunlight, as this property results in an increased loss of radiation. Consequently, in embodiments according to the present invention, where the melanin or the melanin particles isolated according to methods of the present invention are used as selective absorbers for solar thermal energy applications, the removal of additional organic product-related impurities can be omitted. Likewise, based on the present disclosure, this impact on the absorption above 1,100 nm can be utilized for a variety of applications, where the absorption characteristics above 1,000 nm should be influenced in a targeted way.

According to a second aspect of the present invention, there is provided melanin or melanin particles obtainable by a method as for any embodiment of the first aspect above, wherein the melanin or the melanin particles have a particle size distribution of from about 50 nm to about 500 nm as measured by scanning electron microscopy.

The melanin or melanin particles according to the present invention are thus intrinsically different from material as isolated or produced by the prior art and thus are associated with different physico-chemical properties as studied herein. These properties were surprisingly found to allow the use of the melanin or the melanin particles according to the present invention for a variety of applications of solar thermal energy conversion so far not studied or characterized. Detailed parameters for defining the particle size distribution melanin or the melanin particles are described below in the Examples section.

According to one further aspect, there is provided a solar thermal energy selective absorber material comprising melanin or melanin particles, preferably melanin or melanin particles from a *Cephalopoda* animal or melanin or melanin particles according to the second aspect of the present invention, or obtainable by a method according to any embodiment of the first aspect of the present invention.

Based on the analyses as described herein, it was found that the intrinsic properties of melanin or melanin particles are suitable to utilize this material as solar thermal energy selective absorber material due to its immanent properties. As the particle size of the melanin or melanin particles is in the nanometer range, melanin is a suitable nano raw material. In contrast to carbon nanotubes, the isolation and/or production of melanin is cost-effective and no toxic substances are needed for the isolation process. Furthermore, comparing the provision of melanin or melanin particles as presented herein to the provision of other selective absorber materials as detailed above, melanin or melanin particles can be provided in huge amounts and devoid of the use of metal ions and toxic chemicals. The methods, products and uses disclosed herein are thus ecologically beneficial, and, being derived from a natural source, sustainable and environmentally compatible. Based on the disclosure as provided herein, it is further possible to use any natural or synthetic source of melanin and to define a suitable fraction containing particles of a suitable particle size distribution, wherein the melanin or the melanin particles have a particle size distribution in the range from about 10 nm to about 1,000 nm, preferably from about 10 nm to about 800 nm, more preferably from about 10 nm to about 500 nm and most preferably from about 50 nm to about 500 nm as measured by scanning electron microscopy, so that a biomaterial or a synthetic bio-derived material can be provided suitable as selective absorber material for solar thermal energy selective absorber material.

In one embodiment related to solar thermal energy selective absorber material(s), the melanin or the melanin particles are isolated from a natural source, or synthetically, or recombinantly produced. As detailed above, *Cephalopoda* derived melanin or melanin particles are mainly composed of eumelanin. Eumelanin can, however, also be found in a variety of natural sources in huge amounts, including e.g. dark hair, banana peel, fungi, and plant tissues and organs. Many of these melanin resources are readily renewable sources of organic material. Those materials can be easily extracted and tested for there ability to comply with the physic-chemical properties laid out to be mandatory for an efficient and eco-friendly solar thermal energy selective absorber material herein. The use of such materials as solar thermal energy selective absorber materials is thus likewise contemplated herein.

In a further embodiment related to solar thermal energy selective absorber materials, the melanin or the melanin particles are dispersed in a heat transfer fluid.

Heat transfer fluids may be heat-transfer fluids, including fluids in the liquid or gaseous state, in the context of solar thermal energy carry heat through solar collectors and a heat exchanger, for example to the heat storage tanks in solar water heating systems. Several criteria have to be fulfilled for a heat transfer fluid to be suitable for solar thermal energy applications, e.g. the coefficient of expansion, the fractional change in length/volume of a material for a unit change in temperature; the viscosity, i.e. the resistance of a liquid to sheer forces and hence to flow, freezing point and the boiling point and the flash point, i.e. the lowest temperature at which the vapour above a liquid can be ignited in air. One important additional parameter is the thermal capacity also called (effective) heat capacity, i.e the ability of matter to store heat. As detailed above, some nanomaterials used within nano fluids have a good heat capacity and are associated with a good thermal conductivity or heat conductivity, which is needed for heat transfer fluids to transport the energy.

Direct absorption solar collectors use an absorbing fluid for absorbing solar radiation, wherein the absorbing fluid is simultaneously used as heat exchanger as detailed above. Thus, this type of collectors combines two aspects, i.e. the capability of absorbing solar radiation and a good performance and direct heat exchange. So far, despite certain nanofluids which are often expensive in production and toxic, no suitable natural materials exist which can fulfill the dual function of being suitable as solar thermal energy selective absorber material and simultaneously have a high heat capacity. This favourable combined function is associated with the melanin or the melanin particles according to the present invention, which were studied in detail to elucidate their function for a variety of application in solar thermal energy conversion and absorption and/or conduct of energy from solar radiation based on the elaboration of their physic-chemical properties as disclosed herein.

In a further aspect, there is provided solar lacquer or a solar paint comprising as a pigment melanin or melanin particles according to any embodiment of the second aspect of the present invention, or melanin or melanin particles produced as detailed in any embodiment of the first aspect of the present invention, or comprising a solar thermal energy selective absorber material comprising melanin or melanin particles according to any embodiment related to solar thermal energy selective absorber material(s).

Solar lacquers or solar paints are nowadays used for efficient heat management for coatings in all areas of technology including automotive, solar car applications, housing, photovoltaic and the like. The characteristics of solar lacquers or solar paints are largely influenced by the pigments comprised by the solar lacquers or solar paints to formulate suitable surface coatings. Therefore, depending on the specific intended use of a solar lacquer or solar paint, the pigment used for its production can significantly influence the properties of the resulting lacquer/paint and thus its field of application. A solar lacquer comprising melanin or melanin particles according to the present invention will inherently be equipped with the specific absorption characteristics of the melanin or the melanin particles according to the present invention.. As illustrated in the Examples section below, the characteristic optical absorbant properties of the melanin or melanin particles according to the present invention are maintained, when said melanin or melanin particles are used as part of a transparent lacquer or a solar paint, especially a transparent lacquer. Preparing the same formulations using conventional black pigments, however, show unspecific high absorption over the whole UV to the near-IR range (see Fig. 14).

Surprisingly, the melanin or melanin particles isolated by the methods according to the present invention or used according to the present invention especially as solar thermal energy selective absorbers show a high specific heat capacity maximum at about 350 K. As measured by differential scanning calorimetry (see Examples section below and **Fig. 11**). The maximum was observed to be between 25 and 30 J/gK. In comparison to other solids, for example magnesium (1.0 J/gK), iron (0.45 J/gK), copper (0.38 J/gK) or ice (2.06 J/gK) as well as certain fluids, for example water (4.18 J/gK), ethanol (2.43 J/gK) or mercury (0.14 J/gK) this maximum as well as the observed progression of the DSC spectrum is unusual in that structural similarities of the melanin or melanin particles isolated according to the methods of the present invention or used according to the various aspects according to the present invention seem to have structural similarities with the thermal properties as measured and identified for solid matters by DSC measurements, which is further supported by the law of Dulong and Petit. The Dulong-Petit law, a thermodynamic rule proposed in 1819 by French physicists Pierre Louis Dulong and Alexis Thérèse Petit, states that regardless of the nature of a substance, the specific heat capacity c of a solid element (measured in joule per kelvin per kilogram) is equal to 3R/M, where R is the gas constant (measured in joule per kelvin per mole) and M is the molar mass (measured in kilogram per mole). Thus, the heat capacity per mole of many elements is 3R. There are, however, application limits of this law *inter alia* regarding complex molecules due to higher-energy vibrational modes. As further disclosed below (see Example 7 and **Fig. 12**) this behavior concerning the thermal properties of the melanin or the melanin particles seems to be reversible. Due to the above characterized selective wavelength absorption properties as well as the thermal properties of the melanin or the melanin particles isolated according to the present invention or provided according to the present disclosure are specifically suitable as natural melanin source for use them as pigment or selective absorber in solar thermal energy systems. The melanin or the melanin particles according to the various aspects and embodiments according to the present invention absorb energy-rich sunlight in the UV-Vis range below a wavelength of 1,300 nm, which exactly represents the main proportion of sunlight irradiated.

Another advantage associated with the isolated melanin or melanin particles, preferably from a natural source, according to the present invention, is the fact that this melanin shows a low absorption and consequently a high reflection at a wavelength range of 2,000 nm and above. Common solar thermal systems for generating warm water work in a temperature range of up to about 120 °C. A loss of heat radiation thus especially takes place at a wavelength range of above 2,000 nm. Therefore, using the melanin or the melanin particles according to the present invention leads to a significant decrease of the energy loss associated with radiation and an increase of the overall efficiency of a solar thermal system using melanin or melanin particles according to the present invention as pigment or selective absorber or in the form of a solar lacquer or solar paint.

In one embodiment of this aspect, the solar lacquer or the solar paint is independently selected from the group consisting of water-based coatings, preferably dispersions of a polyvinyl ester, a polyvinyl alcohol, a polyvinyl ether, a styrene-butadiene copolymer, or an acrylic, a low solvent high solid coating, preferably an acrylic coating, an unsaturated polyester coating, a polyurethane coating, or a melamine-based resin coating.

Paints and coatings forming the basis for a solar lacquer or solar paint according to the present invention are well known to the skilled person (see Ullmann's Encyclopedia of Industrial Chemistry, Paints and Coatings, 2. Types, 2012. Wiley-VCH, DOI: 10.1002/14356007.o18_o01). The main types of coatings presently available comprise oil-based coatings, cellulose-based coatings, including nitrocellulose lacquers or organic cellulose ester coatings, chlorinated rubber coatings, vinyl coatings, including polyvinyl esters and polyvinyl based copolymers and polyvinyl alcohols, acrylic coatings, alkyd coatings, saturated polyester coatings, unsaturated polyester coatings, polyurethane coatings, epoxy coatings, silicone coatings, urea, benzoguanamine and melamine resins for coatings, phenolic resins for coatings, asphalt, bitumen and pitch coatings, and silicate coatings.

Vinyl resins, including vinyl copolymers, suitable according to the present disclosure according to certain embodiments, are synthesized by polymerization of monomers containing terminal $CH_2=CH$ groups, e.g. polyolefins, poly(vinyl halides) and vinyl halide copolymers, poly(vinyl esters), poly(vinyl alcohol), poly(vinyl acetals), poly(vinyl ethers), and polystyrene. Paints and coating materials based on vinyl resins are generally physically drying. Only in a few cases can vinyl resins be chemically crosslinked with other reactants via incorporated reactive groups. The properties of the paints are therefore primarily determined by the chemical and physical nature of the vinyl resin. Despite the large number of available vinyl resins this class of binders has some common features. All vinyl resins have a linear carbon chain with lateral substituents and exhibit a range of molecular masses. Increasing molecular mass is accompanied by improved mechanical properties, a decrease in solubility, and an increase in the viscosity of their solutions. Vinyl resins of high molecular mass can therefore only be used in the form of dispersions or powders for paint applications. Solvent-containing paints require vinyl resins of considerably lower molecular mass than plastics, since only then sufficient binder content can be achieved in the viscosity range required for paint application. The properties of vinyl resins, paints, and coatings are chiefly determined by the nature and number of substituents. The substituents influence the crystallization behavior and thus the properties of interest in paint technology such as the softening range, mechanical properties (film flexibility, cold embrittlement tendency, film hardness), the film-forming temperature in dispersions, solubility, and compatibility with other binders. Chemical behavior also depends on the substituents: ester groups can be hydrolyzed, free carboxyl groups improve adhesion to metals, and hydroxyl groups permit cross-linking with reactants such as isocyanates. Pigment wetting, pigment loading, water swelling capacity, diffusion of water vapor and other gases, solvent retention, and many other phenomena are also largely determined by the substituents. Copolymerization and the associated introduction of further substituents allows individual properties to be modified. For example, internal plasticization can be achieved by copolymerizing "rigid" monomers with "soft"monomers. Vinyl paints are produced by conventional techniques and can be applied by all conventional methods, e.g., spraying, brushing, roller coating, and dipping). They are dried at room temperature; heating can be used to shorten the drying process.

Polyvinyl esters suitable according to the present disclosure used in paints and adhesives are available as homopolymers and copolymers in the form of solid resins, solutions, and dispersions. Polyvinyl acetate and vinyl acetate copolymers with crotonic acid, vinyl laurate, and dibutyl maleate are important solid resins; some of which are available in solution.

Polyvinyl ester dispersions suitable according to the present disclosure are quantitatively more important than solid resins. Homopolymer and copolymer dispersions are used for binders in emulsion (dispersion) paints, plastic-bonded plasters, and water-thinnable adhesives. Polyvinyl acetate dispersions are less important than vinyl acetate copolymer dispersions. The most important comonomers of vinyl acetate are vinyl laurate, dibutyl maleate, versatic acid esters, ethylene, vinyl chloride, and butyl acrylate. Polyvinyl propionate and copolymers of vinyl propionate with butyl acrylate, styrene, or vinyl chloride are also marketed and used as dispersions. The properties of the films and coatings obtained from dispersions depend primarily on the polymer composition, stabilization system, and particle size. The type of polymer determines film-forming properties, resistance to hydrolysis, and to some extent the water resistance, flammability, and mechanical properties such as flexibility, elongation at break, and tensile strength. The stabilization system (protective colloids such as polyvinyl alcohol and cellulose derivatives or emulsifiers) influences behavior under mechanical stress, pigment and extender compatibility, pigment loading, water resistance, and rheology.

Polyvinyl alcohols suitable according to the present disclosure can be obtained by hydrolysis of polyvinyl acetate. Commercial grades of polyvinyl alcohol differ in the degree of polymerization (molecular mass) and degree of hydrolysis (residual polyvinyl acetate content). The water solubility of these polymers declines with decreasing hydrolysis and increasing molecular mass. Polyvinyl alcohols containing up to 20 wt% vinyl acetate are insoluble in organic solvents. Polyvinyl alcohol is resistant to oils, fats, greases, and waxes. Films obtained from aqueous solutions are clear and colorless, have a high crack resistance, exhibit good lightfastness, and are impermeable to water vapor. Watersoluble organic compounds with highly polar groups and a high boiling point may be used as plasticizers. Polyvinyl alcohol has a good pigment binding capacity and is compatible with the pigments and extenders conventionally used in the paint industry. Therefore, it also is suitable for the use with the melanin or melanin particles according to the present invention. Resistance to water can be improved by reacting the hydroxyl groups with aldehydes or by cross-linking with urea resins or melamine resins in the presence of acid catalysts.

Polyvinyl ethers suitable according to the present disclosure are formed from methyl ethyl ether or isobutyl ether and are used as soft plasticizing resins. Solubility and compatibility depend on the alkyl group. In the paint sector, polyvinyl ethers are used mainly as plasticizing and in some cases as adhesion-improving resins for chlorine-containing binders, styrene polymers, nitrocellulose, and brittle resins.

Polystyrene dispersions suitable according to the present disclosure have a glass transition temperature (Tg) of about100°C. Polystyrene dispersions do not form films at room temperature. These rigid polymers can only be applied with means of heat drying (e.g., to stiffen fabrics and nonwovens). Film formation is not required in agents used to protect floor coverings and paper coatings (plastic pigments).

Soluble styrene copolymers suitable according to certain embodiments of the present disclosure are internally plasticized by acrylate esters, butadiene, maleate esters, or acrylonitrile are presently of greater importance than the homopolymers. The proportion, nature, and molecular mass of the comonomer determine the softening point, solubility, flexibility, drying rate, and resistance to water, UV light, and chemicals. Incorporation of butadiene decreases lightfastness, while acrylic acid confers solubility in alcohol. The range of potential uses thus extends from soft resins for adhesives and paper, to rigid resins for paints and hot-melt adhesives.

Polyacrylates as binders suitable according to the present disclosure consist of copolymers of acrylate and methacrylate esters. Other unsaturated monomers (e.g., styrene and vinyltoluene) may also be incorporated, but usually to a lesser extent. Copolymers formed exclusively from acrylates and/or methacrylates are termed pure acrylics. The comonomers differ as regards the alcohol residues of the ester group, which also allow incorporation of additional functional groups. Choice of suitable monomers allows wide variation of the physical and chemical properties of the resulting polymer. Hydrophilicity, hydrophobicity, and acid - base properties can be adjusted; resins containing hydroxyl, amine, epoxy, or isocyanate groups can also be produced. The resin products may be solids, solutions in organic solvents or water, emulsions, or dispersions. Acrylate resins have several advantages over other paint binders: 1. polyacrylates are only slightly attacked by chemicals, and confer a high degree of resistance to paints; 2. polyacrylates are colorless, transparent, and do not yellow, even after prolonged thermal stress, which makes them suitable for applications in solar thermics in combination with the melanin or melanin particles according to the present invention; 3. polyacrylates do not absorb above 300 nm and are therefore not degraded by UV radiation (as long as they do not contain styrene or similar compounds); 4. polyacrylates do not have unstable double bonds; 5. Polyacrylates have outstanding gloss and gloss retention; and 6. acrylates, and especially methacrylates, are stable to hydrolysis.

The development of low-solvent high-solids paints according to certain embodiments of the present disclosure requires resins with a very low viscosity. The principal viscosity-determining parameters for such binders are the molecular mass and molecular mass distribution. Oligomers with a molecular mass of ca. 1,000 -3,000 are required for high-solids paints. An acrylate binder with a molecular mass of 100,000 can be processed to form a paint with 12.5%solids content at the application viscosity; a molecular mass of ca. 6,000 results in a paint with 50% solids content. Incorporation of functional groups in the polymer skeleton is necessary for the production of dispersions. Most water-dispersible systems are polymers with free carboxyl groups. Binders may also contain basic nitrogen containing groups; dispersion can then occur after neutralization (e.g., with acetic or lactic acid). Since the viscosity of dispersions is very low irrespective of the molecular mass, polymers of very high molecular mass are generally used; dispersions are therefore ideal for physically drying coatings.

In contrast to linear polymers, cross-linked polymers are insoluble and are also harder and more resistant to chemicals; these properties are extremely important for high-grade coatings.

Unsaturated polyester coatings suitable according to the present disclosure are composed of unsaturated polyester resins, hardening (curing) agents, accelerators, promoters, photoinitiators, stabilizers, covering agents (paraffin), air release and leveling agents, pigments, and extenders. Most of the coatings also contain copolymerizable vinyl monomers.

Polyurethane paints or coatings are likewise suitable according to the disclosure of the present disclosure. Polyurethane paint films all have a polymeric structure with urethane, urea, biuret, or allophanate coupling groups. Coupling can occur during paint hardening (curing) as the result of polyaddition of relatively low molecular mass starting products. Alternatively the paints may already contain high molecular mass polymers synthesized by the coupling of appropriate monomers. High molecular mass adducts with excess isocyanate groups or adducts in which curing occurs via oxidation of conjugated double bonds are also common.

Epoxy resins are also suitable as coatings or paints according to the present disclosure. Those epoxy resins are generally not used alone but require a reaction partner in order to be cured. A large number of reaction partners may be used for curing at elevated or at ambient temperature. The cured films have high adhesion, flexibility, hardness, abrasion resistance, resistance to chemicals, and corrosion protection.

Furthermore, according to certain embodiments of the present disclosure, melamine-based resins are suitable as coatings. They are used in both waterborne and solventborne coatings, including high solids industrial coating systems. These amino resins are almost always employed in combination with other flexibilizing functional polymers (backbone polymers) to form highly cross-linked networks. Nowadays, fully alkylated monomeric melamine resins based on hexakis(methoxymethyl) melamine (HMMM) and higher-solids methylated melamine resins have replaced conventional partially butylated amino resins in many applications. Fully alkylated amino resins require strong acid catalysis for fast and/or low-temperature cross-linking. Their catalysis mechanism is different from that of partially alkylated resins which respond to weak acid catalysts or general acid catalysis. A fully alkylated melamine resin catalyzed by a strong acid catalyst is a faster curing (cross-linking) agent than a partially butylated amino resin. The catalysts which are predominately used are p-toluenesulfonic acid, dodecylbenzenesulfonic acid, and dinonylnaphthalenedisulfonic acid, and their amine salts. Compared to partially alkylated amino resins, fully alkylated resins have a lower tendency to undergo selfcondensation and produce films which are hard and still more flexible. Alkylated melamine- formaldehyde resins are the principal cross-linking agents in many industrially applied baked coatings. They are combined with acrylic, alkyd, epoxy, and polyester resins. The amide, hydroxyl, or carboxyl groups of these backbone polymers are used as functional sites for reaction with the amino resin, whereas the choice of the amino component depends on the end use. The largest market for amino resins is in the automotive topcoat area. Most heat-cured automotive primers, primer surfacers, basecoats, and clearcoats utilize melamine cross-linking agents.

The person skilled in the art can thus easily prepare a suitable solar lacquer or solar paint formulation comprising melanin or melanin particles according to the present invention as pigment based on the information provided herein and as available in the field of paints and coatings.

Therefore, according to certain embodiments of the present invention melanin or melanin particles, preferably melanin or melanin particles as isolated according to the first aspect of the present invention and representing a natural pigment can be used as part of any convenient lacquer formulation, especially as part of a solar lacquer or solar paint formulation. In another embodiment according to the present invention any natural or synthetic melanin can be used as pigment constituent of a solar lacquer or solar paint formulation. A suitable lacquer formulation or solar paint formulation should preferably be transparent in the near-IR range at wavelengths of above about 2,000 nm. Additionally, the lacquer formulation or the solar paint should be stable up to working temperatures of about 120 °C. A solar lacquer or a solar paint according to the present invention can additionally comprise a dispersion additive to avoid sedimentation of the melanin or the melanin particles used.

The amount of melanin or melanin particles used as pigment according to the various aspects of the present invention is assessed such that the incoming sun radiation is absorbed as completely as possible. This amount can easily be determined by performing absorption measurements of a suspension and will depend on the layer thickness used. Therefore, the amount can be easily determined by the skilled person based on prior art methods for absorption measurements.

A solar lacquer or a solar paint according to one aspect of the present invention can be applied to a substrate of interest using methods known in the art and including, *inter alia,* methods like painting, sputtering, spraying, emersion, soaking, dipping and the like. A substrate as used herein in the context of solar thermal energy systems can be the surface of e.g. a flat plate collector, or the substrate layer can be the absorber layer within the usual assembly of vacuum tube collectors.

In yet a further aspect, there is provided a solar thermal system comprising melanin or melanin particles, preferably melanin or melanin particles from a *Cephalopoda* animal or melanin or melanin particles any embodiment of the second aspect of the present invention, or obtainable by a method according to any embodiment of the first aspect of the present invention, or comprising a solar thermal energy selective absorber material according to any of the above embodiments related to solar thermal energy selective absorber material(s), or comprising a solar lacquer or a solar paint according to any of the above embodiments related to a solar lacquer or a solar paint.

A solar thermal system can be a solar thermal component or a complete solar thermal system. A solar thermal system can be any system for utilising solar thermal energy, for example for heating, e.g. for heating water, such as for domestic use and the heating of buildings. Likewise, a solar thermal system can be a photovoltaic system or module or a solar cell used for harnessing solar radiation and thus light energy to produce electricity.

In a further aspect, there is provided the use of melanin or melanin particles, preferably melanin or melanin particles from a *Cephalopoda* animal, or of melanin or melanin particles according to any embodiment of the second aspect of the present invention, or of melanin or melanin particles obtainable by a method any embodiment of the first aspect of the present invention, as pigment for solar lacquers or solar paints, or as selective absorber for direct absorption solar collectors, as melanin or melanin particles show superior characteristic towards materials, including further nanomaterials, presently available due to the fact that melanin or melanin particles are extremely tolerant to heat or chemical influences and can thus be applied over a high working temperature range or as stable pigment in a variety of frame formulations, including liquids and solid matters, without loosing their optical absorber or thermal heat capacity properties provided that the particles have a composition, particularly a particle size distribution, as disclosed herein.

The melanin or melanin particles according to these embodiments directed to heat transfer materials, especially heat transfer fluids, are dispersed in common heat transfer fluids, such as water, ethylene glycol, propylene glycol, organic fluids, such as Marlotherm, Diphyl, mineral oils and the like and any combination or mixture thereof. To avoid sedimentation of the melanin or the melanin particles within a heat transfer fluid according to the present invention suspension additives can be further added, which are known to the skilled person.

In embodiments disclosing the use of melanin or melanin particles according to the present disclosure as part of a heat transfer fluid, the concentration of the melanin or the melanin particles is calculated such that over a given layer thickness or coating thickness a maximum of the incoming solar radiation can be absorbed. The skilled person can easily determine said concentration for a given layer thickness using common absorption measurements.

Preferably, a selective absorber according to the present invention comprising melanin or melanin particles, especially in embodiments directed to heat transfer fluids comprising melanin or melanin particles, can be used in direct absorption solar collector systems. For direct absorption solar collectors, the collector area is transparent for sun or solar radiation, usually being made of glass. To avoid a loss of energy due to thermal conduction or convection, a thermal isolation is usually applied, e.g. using an evacuated double-wall tube made of glass. This assembly using melanin or melanin particles isolated according to the methods of the present invention or a selective absorber material according to the present invention comprising melanin or melanin particles has the advantageous property that no metallic absorber surfaces have to be applied and that the selective absorber, for example as part of a pigmented heat transfer fluid, can easily be replaced or substituted without causing high costs of maintenance. Due to the high intrinsic heat capacity of the melanin or the melanin particles as isolated or provided according to the present invention this effect is specifically suitable for direct absorption solar collectors in the usual working temperature range thereof between about 60 °C to about 120 °C as the materials according to the present invention require a lower temperature for transporting the same amount of heat allowing a reduction of the energy loss, especially in the form of waste heat given to the environment, and simultaneously leading to a strongly increased efficiency of a solar thermal system using direct absorption solar collectors based on selective absorbers using melanin or melanin particles as used and isolated according to the present invention.

The present invention will be further illustrated by the following non limiting examples.

## Examples

**Example 1**: Melanin preparation without freezing

As a comparative example melanin from ink sacs was isolated as described in the literature detailed above (see background of the invention). To this end, *Sepia officinalis* or other cephalopods were used as ink comprising animal of interest. Ink sacs were either removed from fresh animals or animals which have been cooled (4 °C) for transport. The ink sac is cut out of the animal and transferred into a petri dish. The ink sac is opened with a scalpel or with scissors. The ink is spilled out of the sac, preferably with demineralized water at room temperature. In one set of experiments, the aqueous suspension was then centrifuged and the solid constituents obtained after centrifugation were freeze-dried and then analyzed by scanning electron microscopy (SEM) as further detailed below (MOld, see **Fig. 1A** and **B**).

Preferably, water is used as solvent for suspending and washing the ink sac material. The usual washing temperature can be between 0 °C to about 100 °C. The amount of water used for suspending the ink sac material can vary depending on intrinsic variations associated with the material as obtained from a natural source and usually will be in the range of about 1 time to 10,000 times the amount of pigment as comprised in an ink sac or a portion thereof. Preferably, the amount of water used for washing should be enough so that the washing fluid will appear colorless, which can be easily determined due to the natural color of the melanin pigment. For drying the melanin or the melanin particles as isolated from the ink sac different temperatures in the range from -20 °C to 150 °C were applied, which all turned out to be suitable. Drying can be performed using any convenient drying method as available to the skilled person, including using drying at the air or gas flow of air or another inert gas. The pressure applied for drying was between 1 mbar up to atmospheric pressure.

Alternatively, the material, in this example from *Sepia officinalis,* was obtained and the ink sacs were opened and purged as detailed above. Next, the material was transferred to a paper filter (retention range 7-12 micron). The filter cake was then washed on the filter with ca. 500 ml demineralized water at room temperature. Logically, the amount of water added for washing can vary depending on the material to be isolated, as there are certain intrinsic variations when working with material of biological origin as detailed above. The remaining powder is dried at 75 to 90 °C in an electrical drying oven or another drying means, for example, a drying cabinet, until the mass remains constant.

Filtration over filter paper without preceding freezing of the ink sac material turned out to be time consuming and the process was associated with a further loss of material and thus a decreased yield. The material was subsequently dried and analyzed via SEM (MF, see SEM in **Fig. 2A** and **B** and **Table 1** below).

Another option for separating the suspended melanin pigment from the aqueous suspension would be decantation to achieve a solid-liquid-separation as known to the person having skill in the art.

For all sets of experiments, melanin or melanin particles are ultimately obtained as powder for further analysis.

**Example 2**: Melanin or melanin particle isolation using a freezing step

Surprisingly it was found that isolation of melanin or melanin particles can be significantly optimized, i.e. concerning yield and time, if either the isolated ink sac or the whole animal comprising the ink sac is subjected to a specific freezing step before extraction of the melanin or melanin particles. Freezing was used either to freeze a whole *Cephalopoda* animal, or it was used for freezing the ink sac removed from the *Cephalopoda* animal before the freezing step. Several animals were tested, including *Sepia officinalis, Dosidicus gigas* and *Octopus vulgaris.* The temperature chosen for the freezing step varied from about -196 °C to about 0°C (liquid nitrogen), from about 0°C to about -78°C (dry ice), and from about 0°C to about -20°C (salt-water mixture). Any of these procedures turned out to be suitable as long as a complete freezing was achieved. Other than when only applying a cooling step, the material as obtained from a *Cephalopoda* animal is thus completely frozen, which also influences the various biomolecules, the cellular and the tissue structures as treated this way during the subsequent downstream processing. The time duration chosen for the freezing step can vary depending on the freezing temperature and conditions chosen. Any time can be used provided that the material subjected to the freezing step is fully frozen and the optimum time for the freezing step can thus be easily determined and varied from a few seconds for liquid nitrogen to several minutes and hours. Overnight freezing at any temperature did not influence the advantageous properties of the melanin material obtained later on. The ink sac was then opened and the ink sac material was obtained by purging the ink sac with water, preferably deminier-alized water, or by means of squeezing the ink into water. The water had a temperature of between 0°C to 100°C, preferably 5°C and 40°C and more preferably between 10°C to 30°C. As melanin as pigment is very stable, an ideal working temperature for this step can be adapted due to the specific needs easily. The slurrying then served to extract and isolate the crude melanin material from the ink sac of the animal, here *Sepia officinalis*. Preferably, the slurrying was accomplished in water, but other solvents or additional additives can be used as well due to the intrinsic stability of the melanin material. Filtering according to the methods of the present invention can then be accomplished, if desired, by using a suitable filter. Preferable filter materials are selected from the group consisting of cellulose, polyamide, cellulose esters and polyester, or any derivatives thereof. The preferable pore size of the filter material is from about 0.5 to about 30 $\mu$m, preferably from about 5 to about 15 $\mu$m, and more preferably from about 7 to about 12 $\mu$m.

The amount of water used for suspending the ink sac material can vary depending on intrinsic variations associated with the material as obtained from a natural source and usually will be in the range of about 1 time to 10,000 times the amount of pigment as comprised in an ink sac or a portion thereof. Preferably, the amount of water used for washing should be enough so that the washing fluid will appear colorless, which can be easily determined due to the natural color of the melanin pigment. For drying the melanin or the melanin particles as isolated from the ink sac different temperatures in the range from -20 °C to 150 °C were applied, which all turned out to be suitable. Drying can be performed using any convenient drying method as available to the skilled person, including using drying at the air or gas flow of air or another inert gas. The pressure applied for drying was between 1 mbar up to atmospheric pressure.

The specific freezing step leads to a significantly different consistency of the melanin particle material comprised in the ink sac in comparison to the material as isolated as described in **Example 1** above. Notably, the material (here MC) has a significantly more granular consistency which can be taken from the SEM pictures in **Figure 3.** Notably it was found that melanin particles isolated by filtration have a different particle size distribution in the range from 100 to 150 nm, which is narrower than the particle size distribution as obtained for the material prepared using a freezing step, where a much broader particle size distribution was observed. This particle size distribution was in the range from 10 nm t0 1,000 nm as normalized over the whole sets of experiments. As an average, a particle size distribution of about 50 nm to about 500 nm was obtained for material of different *Cephalopoda* origin, including samples from *Sepia officinalis.*

Concerning SEM experiments, different melanin samples were analyzed by Electron Microscopy at Laboratório de Microscopia Electrónica, Instituto Superior Técnico (http://microlab.ist.utl.pt/). For the FEG-SEM (field emission gun SEM) analysis, the samples MC, MF and MOld were put on a carbon conductive tape, double coated, using a analytical JEOL 7001 F FEG-SEM (REEQ/711/CTM/2005) instrument.

**Example 3**: Further preparative examples

The following **Table 1** summarizes the examples for several materials isolated according to state of the art methods (MF in **Table 1**, see also Example 1 above) and samples isolated according to the novel freezing method (see also Example 2). Frozen indicates that the material was frozen at a temperature range from about -20°C to about -10°C until the material was completely frozen. Refrigerated implies that the material was only cooled at around 2-4°C, yet no freezing step was applied.

**Table 1**

| Experiment | animal | | purification | | yield | Sample abbreviation |
|---|---|---|---|---|---|---|
| | | | solvent | mixing | | |
| 1 | *Sepia officinalis* | animal frozen | none | -- | >90% | **MC or MCA** |
| 2 | *Sepia officinalis* | ink sac frozen | none | -- | >90% | **MC** |
| 3 | *Sepia officinalis* | ink sac refrigerated | none | -- | 60-70% | **MF** |
| 4 | *Sepia officinalis* | animal refrigerated | none | -- | 60-70% | **MF** |
| 5 | *Sepia officinalis* | ink sac frozen | acetone | agitation | >90% | **MCA** |
| 6 | *Sepia officinalis* | ink sac frozen | 2-butoxyethanol | agitation | >90% | **MC BE** |
| 7 | *Sepia officinalis* | ink sac frozen | 2-butoxyethanol | sonication | >90% | **MC BES** |
| 8 | *Dosidicus gigas* | ink sac frozen | none | -- | >90% | **MCC** |

Notably, the samples MC and MCA represent samples which have been produced in an identical way, but resulting from different batches. The terms MC and MCA thus both represent material as prepared according to the method of the present invention (see experiment 1 of **Table 1** above). For certain downstream processes, the melanin powder or the melanin particles obtained from the procedure above is dispersed in the organic solvent (vol:vol 1:5) at room temperature and agitated for 1 minute and/or sonicated for 2 minutes. After sedimentation of the melanin the supernatant solvent is removed by decantation. The melanin residue is dried in an air flow at room temperature.

Notably, the melanin or melanin particles as isolated using a specific freezing step do not lose their overall morphology or particle size distribution when processed under various conditions. Preparation with hot or cold water did not change the morphology. Likewise, heating to 100°C, 150°C or even 200°C did not alter the morphology as later on verified via SEM. Also the treatment with acids or bases ($NH_3$ aq 30 %)/solvent (e.g. toluene), acetone, cyclohexanone, dichloromethane, 2-Butoxyethanol)/ liquid nitrogen do not have an influence on the morphology of the melanin or the melanin particles as prepared according to this Example or prepared according to the above comparative examples.

**Example 4**: TEM analysis

For the TEM analysis, the samples were dispersed in ethanol and a carbon coated copper grid was dipped in them. Material: Carbon conductive tape, double coated Nisshin EM. Copper grid Ted Pella with a carbon film, 200 mesh. Microscope: FEG-SEM JEOL 7001 F with detector EDS Oxford e EBSD. Microscope: TEM Hitachi 8100 with detector EDS Rontec and digital acquisition of image. TEM images for samples as obtained in Examples 2 and 3 including a specific freezing step are provided in **Fig. 4** to **8**, respectively. As evident from **Fig. 8**, the melanin MCC obtained from *Dosidicus gigas* is significantly different from melanin from *Sepia officinalis.* The particles are significantly larger and are less uniform. Still, these particles as obtained by the specific freezing-isolation as detailed above turned out to be suitable as selective absorbers due to their optical and thermal properties as further detailed below. As evident from the TEM pictures as shown in **Fig. 4** to **8**, there is still organic material surrounding the melanin or the melanin particles, if the material (e.g. MC in **Fig. 4** or MCC in **Fig. 8**) is not further purified. Prior art methods usually seek to isolate and moreover purify melanin particles to remove this organic material by using an organic solvent like acetone or 2-Butoxyethanol. This purification can also be applied here for melanin material purified via a freezing step. It was observed for the first time, however, that the organic material can have an influence on the optical and thermal properties of melanin, which was not studied or analyzed before at all.

**Example 5**: Particle size distribution

The particle size distribution for selected samples, i.e. MC, MF, MC BE and a colored filtrate of MC (turbid filtrate of Example 2) was determined as shown in **Table 2** below. Furthermore, the centrifugate of the turbid filtrate was analyzed after 7 min centrifugation of the turbid filtrate at 3,900 rpm.

**Table 2:**

| Sample | Concentration [%] | Z-Average [nm] |
|---|---|---|
| MC (Fig. 10A) | 0.01 | 224 |
| MF (Fig. 10B) | 0.01 | 212 |
| MC BE (Fig 10C) | 0.01 | 238 |
| Turbid filtrate of MC | | 269 |
| Turbid filtrate of MC after further centrifugation | | 231 |

Notably, the samples were all subjected to filtration prior to the measurement to separate huge aggregates, which would disturb the measurement. Without centrifugation differences appear to be even more pronounced.
TEM measurements as detailed above for Example 4 were conducted. Samples (see **Table 1** and for MOld Example 1) were analyzed using a DLS apparatus (Zetasizer Nano, Malvern) at a temperature of 25 °C. All powder samples were subjected to sonification in an ultrasound bath (Transsonic T310, Elma) 5 min prior to analysis. Samples 1 to 4 were diluted with Millipore water to 0.01% and filtrated using a 1.2 $\mu$m single use disposable filter unit. Samples 5 and 6 were diluted to half the concentration oft he initial material as supplied using Millipore water and were measured after filtration using a 1.2 $\mu$m filter. As evident from **Fig. 16A** and **B**, MOld not subjected to a freezing step, showed a high percentage of aggregates sticking to organic material. The same inhomogeneity, aggregates and sticking to organic material could be observed for material MF (fringed, not frozen, filtration, drying), which was not subjected to a freezing step (see **Fig. 16C** and **D**).
In contrast, material MC (frozen, filtrated, dried) showed significantly decreased aggregation with organic material and provided a homogenous mixture (see **Fig. 16E** and **F**). Also the material MC BE had a denser and more homogeneous appearance and contained less organic material aggregates (see **Fig. 16G** and **H**).

**Example 6:** Absorbance

To further asses the optical properties of the melanin and the melanin particles as isolated and studied in comparison to prior art methods, diffuse reflectance spectroscopy experiments were carried out with the help of the following instrument:

Spectrophotometer Perkin Elmer, Lambda 950; Integrating sphere used as the detector;
Beam Mask "aperture 2" (for an adjustment of beam height to match the sample dimension); Wavelength: 200-2,100nm.

In contrast to absorption data as obtained from the literature (J. Phys. Chem. B., (Vol. 103 (51), 11428 (1999))) the samples of the melanin or the melanin particles as obtained according to the methods of the present invention show a significantly different behavior, i.e. the absorption within the UV-VIS range up to about 1,200 nm is significantly higher than for material as characterized in the prior art. Specifically, there is no decline of absorption between about 200 nm and 800 nm thus also comprising the visible light range which represents the most abundant portion of sunlight. These optical properties of the melanin or the melanin particles as isolated and/or prepared according to the methods of the present invention suggest the use thereof as selective absorber material, especially a solar thermal energy selective absorber material. These data can be derived from **Figure 9.** Melanin or melanin particles isolated from *Sepia officinalis* (MCA, see Example 3) and *Dosidicus gigas* (MCC, see Example 3), both showed high absorption over the whole UV-Vis range as well as the desired low absorption at higher wavelengths (see **Fig. 9**).

**Example 7**: Thermal properties

The samples from Examples 1 to 3 were further analyzed via differential scanning calorimetry (DSC) without further processing of the material. In brief, the ink sac from a *Sepa officinalis* animal was cut out and transferred into a petri dish. The ink sac was opened with a scalpel or scissors. The ink was spilled out of the sac with demineralized water at room temperature and then centrifuged (13,000 g, 20 min.). The precipitated solid was lyophilized to obtain material according to the prior art (MOld, see Example 1 above). Likewise material was prepared according to the methods of the present invention, namely MC and MC BE/MCA BE, as detailed above within Example 3.

The samples were analyzed without further preparation. Material: Linseis calorimeter, DSC-PT10, aluminium crucibles. Conditions: Nitrogen as purge gas, 7-8qnl/h flux of the purge gas, 303.15-473.15K (30-200°C) as working temperature, 2K/min as heating rate.

The specific heat capacity (cf. **Fig. 11**) for different melanin samples shows a maximum at about 350 K independent of the way of isolating/providing the melanin or melanin particles. The maximum is between 25 and 30 J/gK. In comparison to other solid matters, for example magnesium (1.0 J/gK), iron (0.45 J/gK), copper (0.38 J/gK) or ice (2.06 J/gK) as well as certain fluids, for example water (4.18 J/gK), ethanol (2.43 J/gK) or mercury (0.14 J/gK) this maximum as well as the observed progression of the DSC spectrum is unusual in that structural similarities of the melanin or melanin particles isolated or used herein seem to have structural similarities with the thermal properties as measured and identified for solid matters by DSC measurements, which is further supported by the law of Dulong and Petit characterized above.

As can be taken from **Figure 11,** however, the heat capacity of the material MOld is significantly lower than the heat capacity of material produced according to the methods of the present invention, namely MC (see Example 3 above, experiment 1) and the heat capacity is comparable with that of melanin washed with butoxyethanol from experiment 6 (MC BE/MCA BE , see Example 3 above.)

As further shown in a subsequent measurement, (see **Fig. 12**) this behavior of the thermal properties seems to be reversible. Sample MC from Example 1 and measured via DSC as shown in **Fig. 11** was again measured at various time points by means of DSC as follows from **Table 3** below:

**Table 3:**

| Sample | mass before DSC (mg) | mass after DSC (mg) | $\Delta m$ (mg) |
|---|---|---|---|
| MC 1 | 3,23 | 2,41 | 0,82 |
| MC 2 (after analysis of MC 1) | 2,41 | 2,39 | 0,02 |
| MC 3 (5 days after MC 2) | 2,99 | 2,28 | 0,71 |
| MC 4 (12h after MC 3) | 2,91 | 2,42 | 0,49 |

The results of this measurement showing the reversibility of the effect are shown in **Fig. 12** for samples MC 1 to MC 3.

**Example 8**: Solar lacquer

To further elaborate, whether the melanin material purified according to the above method including a freezing step, or melanin material analyzed in detail concerning its optical and thermal properties could be incorporated into a solar lacquer or solar paint for utilizing the advantageous properties of melanin as selective absorber simultaneously providing a high heat capacity, a formulation of a solar lacquer was provided.

To this end, 35% (w/w) of melanin particles from Example 2 were added to a commercial transparent lacquer formulation (Ecrylic RA 646H von ecronova polymer GmbH) and thoroughly mixed to an optical homogeneous mixture. The lacquer was applied to the substrate of the diffuse reflectance spectrometer and the spectra were recorded as detailed above. As comparison, the spectra of the same formulation with carbon nanotubes and commercial universal black dye were prepared as comparative example, which can be taken from **Table 4** below.

**Table 4:**

| Experiment | pigment |
|---|---|
| 9 | MCA BES (Experiment 7 within Example 4) |
| 10 | Carbon nanotubes (CNT) |
| 11 | Universal black (UB) dye |

As evident from **Figures 13** and **14** it could be shown that melanin according to the present invention retains its optical properties when incorporated into a lacquer formulation. As demonstrated in **Fig. 13,** the absorbance curve of the sample L+MC BES B/S incorporated into a transparent lacquer was completely in line with the absorbance curves as measured for MC, B/S and MC BES, B/S (see Example 3 and 4 above) underlying the suitability of a solar lacquer based on the melanin as studied herein. Spectralon as indicated in **Fig. 14** is a brand name and registered trademark. It is a fluoropolymer, which currently has the highest diffuse reflectance of any known material or coating over the ultraviolet, visible, and near-infrared regions of the spectrum. It exhibits highly Lambertian behavior, and can be machined into a wide variety of shapes for the construction of optical components such as calibration targets, integrating spheres, and optical pump cavities for lasers. Absorbance curves were obtained via diffuse reflectance spectroscopy experiments carried out with the help of a Spectrophotometer Perkin Elmer instrument, Lambda 950; Integrating sphere used as the detector; Beam Mask "aperture 2" (for an adjustment of beam height to match the sample dimension); Wavelength: 200-2,100nm.

Comparing now the data as obtained when comparing a MC BES based lacquer to a lacquer based in carbon nanotubes or universal black as pigment it was found that the MC lacquer has a steady and high absorption in the UV-VIS range as well as a steep decline in the near IR-wavelength range, whereas the carbon nanotube lacquer and the universal black lacquer show a high absorption also in the near IR-wavelength range. This high IR absorption, however, is not desired for selective absorbers, as this effect results in a higher loss of radiation. Again, the melanin material as studied herein turned out to be specifically suitable as selective absorber when incorporated into a solar lacquer (see **Fig. 14 A** and **B**).

**Example 9:** Heat transfer fluids, direct absorption solar collectors

Having established that melanin or melanin particles can have characteristics suitable for a selective absorber material in solar thermal energy applications both as absorber as well as a suitable heat transfer material, it was tested whether melanin could be incorporated into heat transfer fluids. Melanin was dispersed in common heat transfer fluids, such as water, ethylene glycol, propylene glycol, organic fluids, such as Marlotherm, Diphyl and mineral oils. To avoid a sedimentation of the melanin or the melanin particles within a heat transfer fluid suspension additives can be added. The heat capacity of melanin as suspended in water was measured and the following comparative results could be obtained with water as heat transfer fluid (Cp=4.18 J/gK):

**Table 5:**

| | melanin | copper | graphite |
|---|---|---|---|
| Heat capacity at 100°C (J/gK) | 25 | 0.4 | 0.7 |

(continued)

| | melanin | copper | graphite |
|---|---|---|---|
| Heat capacity 1 wt% in Wasser (J/gk) | 4.39 | 4.14 | 4.15 |

A nanofluid comprising 1 wt% copper in water and operated in the working temperature range from 60°C to 95°C it transported the same amount of heat as a nanofluid comprising 1 wt% melanin in the working temperature range from 60°C and 93°C. Given the lower costs of melanin and the fact that melanin represents a renewable material, this fact underpins the potential of melanin for use in solar thermal energy applications. In contrast to other absorber materials as presently known and used, melanin has the outstanding advantage of providing a high heat capacity in the working range. Therefore, a lower temperature of the carrier is needed for transporting the same amount of heat. This significantly contributes to an increased efficiency and a decreased loss of heat to the environment. Again, the dual role of melanin as efficient absorber and heat transfer material elucidated herein shows that melanin is a suitable material for direct absorption solar collectors.

**Claims**

1. A method for isolating melanin or melanin particles from the ink sac of a *Cephalopoda* animal comprising the following steps:

   (i) freezing of the *Cephalopoda* animal, or freezing of the ink sac removed from the *Cephalopoda* animal;
   (ii) thawing the *Cephalopoda* animal and removing the ink sac thereof, or thawing the ink sac from the *Cephalopoda* animal;
   (iii) slurrying the solid matter of the ink sac material of the *Cephalopoda* animal in a suitable solvent, preferably in water, to obtain a suspension comprising the melanin or the melanin particles from the *Cephalopoda* animal;
   (iv) optionally: filtration of the suspension comprising the melanin or the melanin particles from the *Cephalopoda* animal; and
   (v) optionally: drying the melanin or the melanin particles from the ink sac material of the *Cephalopoda* animal; and
   (vi) obtaining the melanin or the melanin particles from the ink sac material of the *Cephalopoda* animal.

2. The method according to claim 1, wherein the *Cephalopoda* animal is selected from the group consisting of *Sepia spp., Dosidicus* and *Octopus spp.,* preferably from *Sepia officinalis, Dosidicus gigas* and *Octopus vulgaris.*

3. The method according to claims 1 or 2, wherein the melanin or the melanin particles have a particle size distribution in the range from about 10 nm to about 1,000 nm, preferably from about 10 nm to about 800 nm, more preferably from about 10 nm to about 500 nm and most preferably from about 50 nm to about 500 nm as measured by scanning electron microscopy.

4. The method according to any one of the preceding claims, wherein the melanin or the melanin particles show an absorbance of above 90%, preferably of above 95% in the wavelength range from about 250 nm to about 950 nm and a decline of absorbance starting from about 85% to about 90% at a wavelength from about 1200 nm down to an absorbance of about 22% to about 50% at a wavelength of about 1600 nm as measured by diffuse reflectance spectroscopy.

5. The method according to any one of the preceding claims, wherein the freezing step (i) comprises freezing the *Cephalopoda* animal, or freezing of the ink sac removed from the *Cephalopoda* animal at a temperature from about -196 °C to about 0°C, preferably at a temperature from about 0°C to about -78°C, and most preferably from about 0°C to about -20°C.

6. The method according to any one of the preceding claims, wherein the method does not contain a step of removing product-related impurities, and/or wherein the melanin or the melanin particles are associated with organic material, wherein the organic material is derived from the ink sac of a *Cephalopoda* animal, or wherein the organic material is a synthetic organic material, optionally wherein the organic material comprises collagen.

7. Melanin or melanin particles obtainable by a method as detailed in any of the preceding claims, wherein the melanin or the melanin particles have a particle size distribution of from about 50 nm to about 500 nm as measured by scanning electron microscopy.

8. A solar thermal energy selective absorber material comprising melanin or melanin particles, preferably melanin or melanin particles from a *Cephalopoda* animal or melanin or melanin particles according to claim 7, or obtainable by a method according to any one of claims 1 to 6.

9. The solar thermal energy selective absorber material according to claim 8, wherein the melanin or the melanin particles are isolated from a natural source, or synthetically, or recombinantly produced.

10. The solar thermal energy selective absorber material according to any one of claims 8 or 9, wherein the melanin or the melanin particles are dispersed in a heat transfer fluid.

11. A solar lacquer or a solar paint comprising as a pigment melanin or melanin particles according to claim 7, or melanin or melanin particles produced as detailed in any one of claims 1 to 6, or comprising a solar thermal energy selective absorber material comprising melanin or melanin particles according to any one of claims 8 to 10.

12. The solar lacquer or the solar paint comprising melanin or melanin particles according to claim 11, wherein the solar lacquer or the solar paint is independently selected from the group consisting of water-based coatings, preferably dispersions of a polyvinyl ester, a polyvinyl alcohol, a polyvinyl ether, a styrene-butadiene copolymer, or an acrylic, a low solvent high solid coating, preferably an acrylic coating, an unsaturated polyester coating, a polyurethane coating, or a melamine-based resin coating.

13. A solar thermal system comprising melanin or melanin particles, preferably melanin or melanin particles from a *Cephalopoda* animal or melanin or melanin particles according to claim 7, or obtainable by a method according to any one of claims 1 to 6, or comprising a solar thermal energy selective absorber material according to any one of claims 8 to 10, or comprising a solar lacquer or a solar paint according to any one of claims 11 or 12.

14. Use of melanin or melanin particles, preferably melanin or melanin particles from a *Cephalopoda* animal, or of melanin or melanin particles according to claim 7, or of melanin or melanin particles obtainable by a method as detailed in any one of claims 1 to 6, as pigment for solar lacquers or solar paints, or as selective absorber for direct absorption solar collectors.

15. The use according to claim 14, wherein the melanin or the melanin particles is/are used as selective absorber in a heat transfer fluid and/or within a solar thermal system.

Figure 1

A                                    B

Figure 2

A                                    B

Figure 3

A                                        B

Figure 4

**Figure 5**

**Figure 6**

**Figure 7**

**Figure 8**

**Figure 9**

Comparison of the absorbance between melanin from the Atlantic with different washings and melanin from the Pacific, baseline with substrate

**Figure 10**

B

C

**Figure 11**

**Figure 12**

**Figure 13**

Comparison of the absorbance between melanin from the Atlantic with different washings and its incorporation in a lacquer, baseline with substrate

**Figure 14**

Comparison of the absorbance between the same lacquer with different pigments, standard baseline with Spectralon

A

**Comparison of the absorbance between the same lacquer with different pigments, standard baseline with Spectralon**

B

**Figure 15**

Melanin
Tape
Substrate

A

Paint
Substrate

B

**Figure 16**

A

B

C

D

E

F

G

H

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2009046621 A
- WO 03030194 A1

- CN 101915459 A

### Non-patent literature cited in the description

- **CLAES G. GRANQVIST.** Kirk-Othmer Encyclopedia of chemical technology. 27 January 2006
- *Pigment and Cell Research,* 1992, vol. 5, 143
- *PIGMENT AND CELL RESEARCH,* 2003, vol. 16, 72
- *PIGMENT AND CELL RESEARCH,* 2003, vol. 16, 606
- *Pigment and Cell Research,* 2005, vol. 18, 42
- *Comp. Biochem. Physiol.,* 1980, vol. 68B, 415
- *Biochimica and Biophysica Acta,* 1988, vol. 964, 193
- *Biochemische Zeitschrift,* 1909, vol. 16, 37
- **BARDANI L. et al.** Comparative Mössbauer and infrared analysis of iron-containing melanins. *Biochim. et Biophys. Acta,* vol. 716 (1), 8-15
- **DERBY C.D.** Escape by Inking and Secreting: Marine Molluscs Avoid Predators Through a Rich Array of Chemicals and Mechanisms. *Biol. Bull. 2013,* December 2007, 274-289

- **MAGARELLI et al.** Purification, characterization and analysis of sepia melanin from commercial sepia ink (Sepia officinalis). *Revista CES Medicina Veterinaria y Zootecnia,* 2010, vol. 5 (2
- *J. Phys. Chem. B.,* 1999, vol. 103 (51), 11428
- *Renewable and Sustainable Energy Reviews,* 2014, vol. 38, 88-98
- *Solar energy,* 1975, vol. 17, 179-183
- *Nanoscale Research Letters,* 2011, vol. 6, 225
- *Journal of Renewable and Sustainable Energy,* 2010, vol. 2 (3), 33102
- *Renewable and Sustainable Energy Reviews,* 2013, vol. 28, 232-245
- *Energy Conversion and Management,* 2015, vol. 100, 324-346
- *Light: Science and applications,* 2012, vol. 2, e34
- Ullmann's Encyclopedia of Industrial Chemistry, Paints and Coatings. Wiley-VCH, 2012